(19) **Europäisches Patentamt**
European Patent Office
Office européen des brevets

(11) **EP 1 615 062 B1**

(12) **EUROPÄISCHE PATENTSCHRIFT**

(45) Veröffentlichungstag und Bekanntmachung des Hinweises auf die Patenterteilung:
**16.04.2008  Patentblatt 2008/16**

(51) Int Cl.:
*G02B 21/00* (2006.01)     *G03F 7/20* (2006.01)
*G02B 5/30* (2006.01)

(21) Anmeldenummer: **05014397.3**

(22) Anmeldetag: **02.07.2005**

(54) **Mikroskopisches Abbildungssystem und Verfahren zur Emulation eines hochaperturigen Abbildungssystems, insbesondere zur Maskeninspektion**

Microscopic imaging system and procedure for the emulation of a high aperture imaging system, in particular for mask inspection

Système d'imagerie microscopique et procédé d'émulation d'un système d'imagerie à haute ouverture numérique, en particulier pour l'inspection de masques

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **08.07.2004   DE 102004033603**

(43) Veröffentlichungstag der Anmeldung:
**11.01.2006   Patentblatt 2006/02**

(73) Patentinhaber: **Carl Zeiss SMS GmbH**
**07745 Jena (DE)**

(72) Erfinder:
 • **Harnisch, Wolfgang**
   **07778 Lehesten (DE)**
 • **Schuster, Karl-Heinz**
   **89551 Königsbronn (DE)**
 • **Scherübl, Thomas**
   **07745 Jena (DE)**
 • **Greif-Wüstenbecker, Jörn**
   **1030 Wien (AT)**
 • **Rosenkranz, Norbert**
   **07629 Reichenbach (DE)**

 • **Totzeck, Michael**
   **73525 Schwäbisch Gmünd (DE)**
 • **Strössner, Ulrich**
   **07745 Jena (DE)**
 • **Feldmann, Heiko**
   **73432 Aalen (DE)**
 • **Gruner, Toralf**
   **73433 Aalen-Hofen (DE)**

(74) Vertreter: **Muhsfeldt, Willi**
**Carl Zeiss Jena GmbH**
**Servicebereich Recht und Patente**
**Carl-Zeiss-Promenade 10**
**07745 Jena (DE)**

(56) Entgegenhaltungen:
**US-A1- 2004 125 373      US-B1- 6 657 736**
**US-B1- 6 690 469**

 • **T. G. BROWN: "Inhomogeneous Polarization in Optical System Design" INTERNATIONAL OPTICAL DESIGN CONFERENCE, Bd. 4832, 2002, Seiten 198-205, XP002353050**

**Beschreibung**

Die vorliegende Erfindung betrifft ein optisches Abbildungssystem für Inspektionsmikroskope, mit denen Lithographiemasken insbesondere durch die Emulation hochaperturiger Scannersysteme auf Fehler geprüft werden können.

Immer kleiner werdende Objektstrukturgrößen erfordern immer größere abbildungsseitige numerische Aperturen von Scannersystemen. Durch die damit immer auch größer werdenden Einfallswinkel kommt es allerdings zu den sogenannten Vektoreffekten, bei denen tangential- und radial-polarisierte Strahlungsanteile unterschiedliche Intensitätsverläufe aufweisen. Es zeigt sich, dass die Strahlungsanteile, die parallel zu der durch Einfallsrichtung und Flächennormale des Substrates aufgespannten Einfallsebene schwingen (s-polarisiert), besser interferiert und somit einen besseren Kontrast erzeugen, als die senkrecht dazu schwingenden Strahlungsanteile (p-polarisiert). Diese sogenannten Vektoreffekte führen zu einem sinkenden Kontrast für p-polarisierte Anteile der Strahlung und dadurch zu einem sinkenden Gesamtkontrast bei Scannersystemen mit großen abbildungsseitigen numerischen Aperturen.

Für die weitere Beschreibung wird folgende Definition zugrunde gelegt: Licht ist eine transversale elektromagnetische Welle, dessen Feld senkrecht zur Ausbreitungsrichtung schwingt. Licht dessen Feldvektor E nur in einer Richtung schwingt, heißt linear polarisiertes Licht. Die Polarisationsrichtung ist dabei die Richtung in die der Feldvektor E schwingt. Der einfallende und der reflektierte Strahl definiert die sogenannte, senkrecht zur Grenzfläche der beiden Medien stehende, Einfallsebene. Licht, dessen Polarisationsebene senkrecht zur Einfallsebene liegt, heißt s-polarisiertes und Licht, dessen Polarisationsebene parallel zur Einfallsebene liegt, p-polarisiertes Licht.

Tangentiale (s-)Polarisation liegt vor, wenn das Licht in der Pupille eines optischen Systems linear polarisiert ist und sich die Polarisationsrichtung dabei über die Pupille ändert, so dass die Polarisationsrichtung in jedem Ort der Pupille tangential zur optischen Achse (senkrecht zum Radiusvektor) steht. Radial (p-)Polarisation liegt hingegen vor, wenn die Polarisationsrichtung in jedem Ort der Pupille radial zur optischen Achse (parallel zum Radiusvektor) steht.

Die aktuelle Roadmap der Halbleiterindustrie favorisiert den Einsatz von Immersionssystemen zur Herstellung von Waferstrukturen kleiner als 65nm. Durch das Aufbringen einer Immersionsflüssigkeit auf dem Wafer werden abbildungsseitige numerische Aperturen NA > 1 erreicht, so dass bei gleicher Wellenlänge kleinere Strukturen erzeugt werden können. Bei einer Wellenlänge von $\lambda$ = 193 nm und der Verwendung von Wasser als Immersionsflüssigkeit kann so eine maximale NA = 1,4 erreicht werden. Durch die Verwendung anderer Immersionsflüssigkeiten können noch größere NA erreicht werden. Bei einem Reduktionsfaktor von 1:4 sind somit Waferstrukturen von 65nm bzw. 45nm für Maskenstrukturen von 260nm bzw. 180nm erforderlich. Da die Maskenstrukturen somit im Bereich der Abbildungswellenlänge (193nm) liegen, werden auch die Polarisationseffekte durch die Masken immer dominanter.

Diese p-polarisierten Strahlungsanteile werden bei der Abbildung einer Lithographiemaske durch Scannersysteme anders abgebildet als durch ein Inspektionsmikroskop. Durch die vergrößerte Abbildung der Lithographiemaske auf eine CCD-Matrix ist die abbildungsseitige numerische Apertur hierbei extrem gering, so dass Vektoreffekte nicht auftreten. Wird nun ein Mikroskop dazu verwendet Lithographiemasken durch die Emulation eines Scannersystems zu inspizieren, so sind die auftretenden Vektoreffekte zur Begutachtung der Lithographiemaske unbedingt erforderlich, da ein reales Abbild des Scannersystems sonst nicht erzeugt werden kann.

Bei den nach dem Stand der Technik bekannten Inspektionsmikroskopen ist die Berücksichtigung von Vektoreffekten bisher nicht implementiert, da die numerischen Aperturen der verwendeten Abbildungssysteme < 1 sind und Vektoreffekte somit zu einem untergeordneten Fehler führen.

*Die* US 6,690,469 B1 *beschreibt ein Verfahren und ein Gerät, mit welchem anhand hochaufgelöster, optischer Abbilder feine Defekte, insbesondere in den Mustern eines Halbleiterelements detektiert werden könne. Das Inspektionsgerät verfügt dabei neben einer Haltevorrichtung für die Befestigung einer Probe, einer Beleuchtungseinheit zum Belichten und einer Detektionseinheit zur Einfassung des optischen Bildes der Probe, über ein Display zur Anzeige des optischen Bildes, eine Steuereinheit zur Variation der Beleuchtungsparameter, eine Speichereinheit und einer Detektionseinheit, von der die Defekte anhand zweier, mit verschiedenen Polarisationszuständen aufgenommener Bilder. Bei dem in Reflektion arbeutenden System wird elliptisch polarisiertes Licht verwendet.*

*Ein Mikroskopsystem zur Bestimmung der optischen Eigenschaften einer Probe, unter Verwendung polarisierten Lichtes, wird in* US 6,924,893 B2 *beschrieben. Das von der Beleuchtungsquelle ausgesendete Licht wird durch mehrere im Strahlengang angeordnete Polarisationselementen, deren Lage bzw. Stellung von einer Steuereinheit geregelt wird, polarisiert und auf die zu untersuchende Probe geleitet. Das Abbild der Probe wird über einen, im Strahlengang angeordneten Analysator auf einem Detektor abgebildet, an eine Auswerteeinheit weitergeleitet und auf einem Display dargestellt.*

Die Analyse von Defekten im Maskenherstellungsprozess wird damit bei kleineren Strukturen immer wichtiger. Zu Analyse von Maskendefekten hinsichtlich Printability ist seit 10 Jahren das AIMS™ (Aerial Imaging Measurement System) der Carl Zeiss SMS GmbH im Markt etabliert. Dabei wird ein kleiner Bereich der Maske (Defektort) mit den gleichen Beleuchtungs- und Abbildungsbedingungen (Wellenlänge, NA, Sigma, Polarisation) wie im lithographischen Scanner beleuchtet und abgebildet. Im Gegensatz zum Scanner wird jedoch das von der Maske erzeugte Luftbild auf eine CCD Kamera vergrößert. Die Kamera sieht das gleiche Bild wie der Resist auf dem Wafer. Somit kann ohne aufwändige Testprints das Luftbild analysiert werden. Durch Aufnahme einer Fokusreihe bekommt man zusätzliche Informationen zur Analyse des lithographischen Prozessfensters.

Während der Lithographiescanner die Maskenstruktur verkleinert auf den zu belichtenden Träger abbildet, wird bei der Maskeninspektion hingegen die Struktur vergrößert auf einen Detektor abgebildet. Bei beiden Systemen ist die maskenseitige Numerische Apertur gleich.

Nach Stand der Technik spielen die Abbildungsseitigen Unterschiede zwischen Scanner und dem Emulationsmikroskop eine untergeordnete Rolle. Bei steigender abbildungsseitiger numerischer Apertur des Scanners steigt dieser Unterschied und kann nicht mehr vernachlässigt werden. Dieser in der Scannerabbildung auftretende Effekt wird Vektoreffekt genannt.

Der vorliegenden Erfindung liegt die Aufgabe zugrunde, eine Lösung für Lithographiemasken Inspektionsmikroskope zur Scanneremulation zu entwickeln, die es ermöglicht auch die Abbildungen von Scannsystemen mit einer abbildungsseitigen numerischen Apertur größer als 1 zu emulieren.

Erfindungsgemäß wird die Aufgabe durch die Merkmale der unabhängigen Ansprüche gelöst. Bevorzugte Weiterbildungen und Ausgestaltungen sind Gegenstand der abhängigen Ansprüche.

Mit der vorgeschlagenen Lösung ist es möglich Lithographiemasken, trotz immer kleiner werdenden Strukturen und immer höheren abbildungsseitigen NA der Abbildungssysteme, mit Hilfe von Inspektionsmikroskopen mit großen Vergrößerungen auf Defekte zu untersuchen. Es können reale Abbildungen der Steppersysteme durch Emulation der auftretenden Vektoreffekte erzeugt werden.

Die vorgeschlagene Lösung ist auch in anderen optischen Systemen anwendbar, bei denen die Eigenschaften einer hochaperturigen Abbildungsoptik durch eine niederaperturige Abbildungsoptik emuliert werden sollen, um entsprechende Effekte zu betrachten und/oder zu berücksichtigen.

Die Erfindung wird nachfolgend anhand von Ausführungsbeispielen näher beschrieben. Dazu zeigen

Figur 1:     einen s/p-Strahlteiler in einem konvergenten Strahlengang,

Figur 2:     den Strahlverlauf eines s/p-Strahlteilers zwischen zwei Zylinderlinsen,

Figur 3:     die normierten Intensitätsverläufe der s- und p-polarisierten Strahlungsanteile in einem Scannersystem und einem Inspektionsmikroskop im Vergleich,

Figur 4:     die winkelabhängige Wichtung der zur Bilderzeugung beitragenden Strahlungsanteile,

Figur 5:     ein mikroskopisches Abbildungssystem mit einem die Intensität schwächenden optischen Element

Figur 6:     ein Schema zur Addition verschobener Abbilder

Figur 7:     ein Schema zur Ermittlung normierter Punktbilder für s- und p-polarisierte Strahlungsanteile und

Figur 8:     eine emulierte Intensitätsverteilung für p-polarisierte Strahlungsanteile im Vergleich zu denen im AIMS und in einem Scanner.

Abbildungssystem zur Simulation hochaperturiger Scannersysteme

Das erfindungsgemäße mikroskopische Abbildungssystem zur Emulation hochaperturiger Scannersysteme, insbesondere zur Maskeninspektion, besteht aus einer Beleuchtungs- und Abbildungsoptik, einem Detektor und einer Auswerteeinheit. Dabei werden polarisationswirksame optische Bauelemente zur Erzeugung unterschiedlicher Polarisationszustände der Beleuchtungsstrahlung im Beleuchtungsstrahlengang und/oder im Abbildungsstrahlengang zur Selektion der unterschiedlichen Polarisationsanteile der Abbildungsstrahlung wahlweise angeordnet. Ein optisches Bauelement mit polarisationsabhängiger Intensitätsschwächungsfunktion kann dabei in den Abbildungsstrahlengang eingebracht werden kann. Vom Detektor werden Abbilder der Maske und/oder Probe für unterschiedlich polarisierte Strahlungsanteile aufgenommen. Im Anschluss werden von einer Auswerteeinheit die Abbilder für unterschiedlich polarisierte Strahlungsanteile zu einem Gesamtbild zusammengefasst. z.B. Dies geschieht beispielsweise durch Addition deren Intensitätsverteilungen.

Polarisationswirksame optische Bauelemente

Im folgenden wird auf die polarisationswirksamen optischen Bauelemente näher eingegangen. Diese können sowohl im Beleuchtungsstrahlung zur Erzeugung unterschiedlicher Polarisationszustände als auch im Abbildungsstrahlengang zur Selektion unterschiedlicher Polarisationsanteile angeordnet sein.

In einer ersten Ausführungsform wird als polarisationswirksames optisches Bauelement eine aus zwei Linsen oder Linsengruppen, mit mindestens einer dazwischen positionierten polarisationswirksamen Schicht, bestehende optische Baugruppe verwendet. In einer besonders vorteilhaften Ausgestaltung ist die polarisationswirksame Schicht als s/p-Strahlteiler im 2-f-Aufbau ausgeführt.

Dabei wird ein s/p-Strahlteiler zwischen zwei Linsen o. a. Linsensystemen mit hoher numerischer Apertur eingebracht. Die beiden Linsen sind so angeordnet, dass sie einen 2-f-Aufbau bilden. Durch die erste Linse oder Linsengruppe, die insgesamt eine positive Brechkraft aufweist, wird aus dem weitgehend parallelen ein konvergentes Strahlenbündel mit einer definierten ersten Winkelverteilung erzeugt.

Zwischen den beiden Linsen oder Linsengruppe befinden sich ein oder mehrere s/p-Strahlteiler, die jeweils aus einer senkrecht zur optischen Achse ausgerichteten planparallelen, transparenten Platte und einer auf der Eintrittsund/oder Austrittsseite der Platte aufgebrachte Polarisationsteilerschicht bestehen. Der in Transmission genutzte s/p-Strahlteiler hat einen praktisch vernachlässigbaren Einfluss auf die Winkelverteilung der Strahlung, so dass an ihrer Austrittsseite ein Strahlbündel austritt, dessen Winkelverteilung im wesentlichen der Winkelverteilung nach der ersten Linse oder Linsengruppe entspricht.

Mit Abstand hinter dem s/p-Strahlteiler ist eine winkelverändernde zweite Linse oder Linsengruppe angeordnet, die mit Hilfe insgesamt positiver Brechkraft, das ankommende divergente Strahlbündel in ein weitgehend paralleles Strahlenbündel transformiert. Die vordere Brennebene der zweiten Linse oder Linsengruppe fällt dabei mit der hinteren Brennebene der ersten Linse oder Linsengruppe zusammen, so dass insgesamt eine sogenannte 2-f-Anordnung gebildet wird. Zwischen den Linsen oder Linsengruppen befinden sich ein oder mehrere s/p-Strahlteiler.

Die s/p-Strahlteiler bestehen dabei aus einem dielektrischen Mehrlagen-Wechselschichtsystem, bei dem Einzelschichten aus hochbrechendem dielektrischen Material und niedrigbrechenden dielektrischen Material abwechseln übereinander aufgebracht sind. Es sind aber auch unbeschichtete Platten mit möglichst hoher Brechzahl verwendbar. An den Grenzflächen des Schichtsystems unterscheiden sich die Reflexionsgrade $R_p$ für p-polarisiertes Licht und $R_s$ für s-polarisiertes Licht bei nichtsenkrechtem Lichteinfall so, dass insgesamt eine der Polarisationskomponenten stärker transmittiert und die andere stärker reflektiert wird.

Im Extremfall kann der s-polarisierte Strahlungsanteil reflektiert und der p-polarisierte Strahlungsanteil transmittiert werden. Am Ausgang der zweiten Linse würde dann nur der p-polarisierte Strahlungsanteil in kollimierter Form vorliegen. Bei Verwendung eines s/p-Strahlteilers der s-polarisierte Strahlungsanteile transmittiert, liegt dann nur der s-polarisierte Strahlungsanteil in kollimierter Form vor.

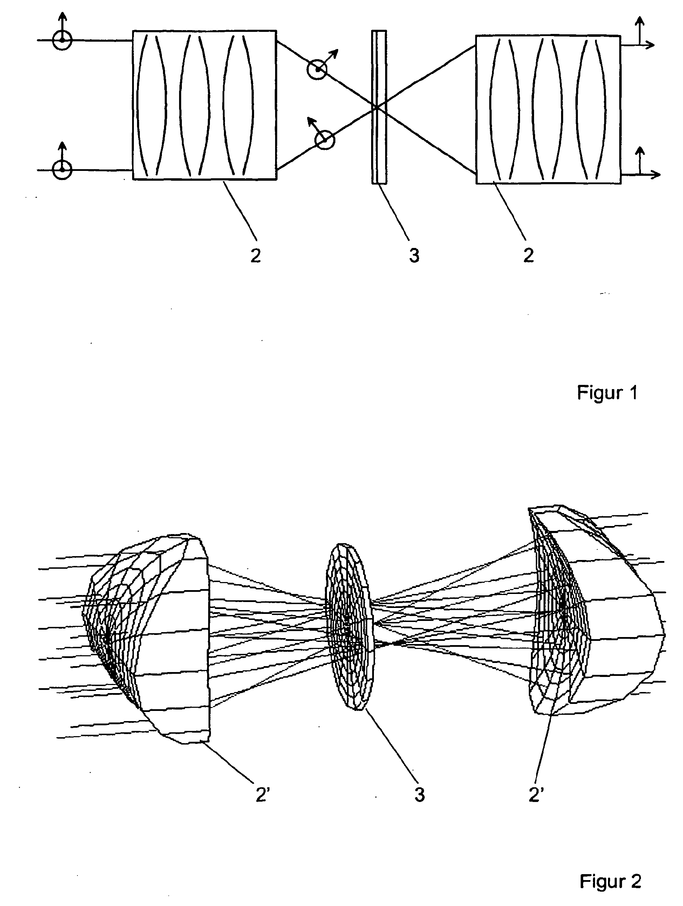

**Figur 1** zeigt hierzu einen s/p-Strahlteiler **3** im konvergenten Strahlengang in einer hochaperturigen Ein- und Auskoppeloptik **2.** Die auf einem planaren Substrat aufgebrachte s/p-Strahlteilerschicht sollte so ausgelegt sein, dass gerade im Bereich hoher numerischer Aperturen, d. h. großer Einstrahlwinkel, eine maximale Polarisationswirkung erzielt wird.

Das gleiche Prinzip kann auch genutzt werden, um einen überwiegend tangential polarisierten Ausgangspolarisationszustand hinter der Auskoppeleinrichtung **2** zu erzeugen. Hierzu wird ein s/p-Strahlteiler **3** verwendet, der s-polarisierte Strahlenanteile stärker transmittiert als p-polarisierte. Auch hier sind die Reflexionsgrade $R_s$ und $R_p$ bei senkrechtem Lichteinfall gleich, danach ergeben sich jedoch unterschiedliche Reflexionsgrade für s- und p-polarisierte Strahlungsanteile.

In beiden Fällen entsteht am Ende des s/p-Strahlteilers im 2-f-Aufbau ein Strahlenbündel, bei dem der Polarisationsgrad, d. h. die Stärke der Ausprägung einer Polarisationsvorzugsrichtung, von der Mitte der Pupille zum Rand hin zunimmt. Dies kann dahingehend vorteilhaft sein, dass die Polarisationsverteilung an besondere Bedürfnisse der Abbildung angepasst werden können.

Mit einer derartigen Anordnung kann aus einem Strahlenbündel, welches unpolarisiert ist oder eine gegebene örtliche Verteilung von Polarisationszuständen hat, ein Strahlenbündel mit einer demgegenüber veränderten Ortsverteilung von Polarisationszuständen erzeugt werden. Der s/p-Strahlteiler ist dabei so ausgelegt, dass er für p-polarisierte Strahlungsanteile ein höheres Transmissionsvermögen als für s-polarisierte Strahlungsanteile aufweist. Durch andere Auslegung ist es aber auch möglich, dass s/p-Strahlteiler für s-polarisierte Strahlungsanteile ein höheres Transmissionsvermögen als für p-polarisierte Strahlungsanteile hat. Hierdurch kann insbesondere tangential polarisierte Strahlung erzeugt werden.

Winkelselektiv wirksame Strahlteiler mit einer oder mehreren polarisierenden Schichten haben in der Regel geringen Bauraumbedarf und können gegebenenfalls durch Modifikation existierender optischer Komponenten in einem optischen System realisiert werden. Der s/p-Strahlteiler mit einer oder mehreren polarisationswirksamen Schichten kann beispielsweise als planparallele Platte, mit einer im wesentlichen über den gesamten Querschnitt konstanten Winkelverteilung, ausgeführt sein.

In einer anderen Ausführungsform kann der s/p-Strahlteiler mit einer oder mehreren polarisationswirksamen Schichten auf einer konvex oder konkav gekrümmten Substratoberfläche aufgebracht sein, wobei die Winkelverteilung dann eine Funktion des Ortes bzw. des Abstandes von der optischen Achse ist. Als gekrümmten Substratoberfläche kann dabei die Oberfläche einer Linse verwendet werden, auf die die Randstrahlen unter hohen Einfallswinkeln auftreffen.

Um den radialen Verlauf der Strahlbeeinflussung gezielt den Bedürfnissen anzupassen, kann die Strahlteilerschicht auch inhomogen aufgebracht werden.

Wenn in dem optischen System eine hohe NA bereits vorhanden ist, kann die Strahlteilerschicht in diese eingebracht werden, so dass die Linsen oder Linsengruppen nicht zusätzlich erforderlich sind.

Alternativ kann vor dem s/p-Strahlteiler eine Platte aus einem optisch aktiven Medium eingebracht werden, die in Abhängigkeit von dessen Dicke zu einer Rotation des Polarisationszustandes führt. Wird die Dicke so gewählt, dass gerade eine Rotation um 90˚ erfolgt, wird beispielsweise der p-polarisierte Strahlungsanteil vor dem s/p-Strahlteiler in einen s-polarisierten Strahlungsanteil überführt und transmittiert. Dadurch kann die Intensität der Beleuchtungsstrahlung wesentlich erhöht werden. Hinter dem s/p-Strahlteiler kann die Konversion mit einer zweiten optisch aktiven Platte wieder rückgängig gemacht werden. Es ist auch möglich statt einer Platte aus optisch aktiven Medium zwei um 45˚ gegeneinander verdrehte Lambda/2-Verzögerungsplatten zu verwenden.

Vorteilhafterweise würde man verschiedene Strahlteiler vorsehen, die entweder p-polarisierte oder s-polarisierte Strahlungsanteil transmittieren und diese so anordnen, dass sie im Bedarfsfall in den Strahlengang eingebracht werden können.

Bei einer weiteren Variation werden einzelne Positiv-Meniskuslinsen mit weitgehend korrigierter sphärischer Aberration verwendet, so dass die kollimierte Strahlung in eine zum Fokus konvergierende Kugelwelle umgeformt wird, und die hinter dem Fokus wieder divergierende Kugelwelle wieder in ein achsparalleles Strahlenbündel transformiert wird. Zur Minimierung der Strahlungsbelastung des s/p-Strahlteilers sollte dieser nicht im Fokus der Ein- und Auskoppeloptik, sondern davor bzw. dahinter liegen. Die transmittierte Welle ist invariant gegen eine achsparallele Verschiebung des s/p-Strahlteilers. Da die reflektierte Strahlung durch eine solche Verschiebung jedoch verändert wird, kann man beispielsweise den Fokus der reflektierten Welle nutzen, um die reflektierte Strahlung gezielt zu blockieren oder auszukoppeln. In diesem Zusammenhang ist es vorteilhaft den s/p-Strahlteiler vor den Fokus zu bringen und im Fokus selbst ein Blende anzuordnen, die auftretende Streustrahlung blockiert.

Während bei einer auf den s/p- Strahlteiler einfallenden Strahlung mit sphärischer Wellenfront s- oder p-polarisierte Strahlungsanteile transmittiert werden, können bei asphärisch geformten Wellenfronten auch allgemeine Polarisationszustände generiert werden.

**Figur 2** zeigt hierzu den Strahlverlauf bei einem s/p-Strahlteiler **3** zwischen zwei Zylinderlinsen **2'**. Eine Zylinderlinse **2'** erzeugt eine quer zur Zylinderachse zunehmende lineare Polarisation.

Durch rotationssymmetrische Asphären lassen sich die Beziehungen zwischen der Strahlhöhe vor der Einkoppeloptik und dem Einfallswinkel auf die s/p-Strahlteilerschicht variieren und der radiale Verlauf der Polarisation steuern.

Werden zum Beispiel für den s/p-Strahlteiler im 2-f-Aufbau ausschließlich Linsen mit sphärischen Linsenflächen verwendet, so dass das auf den Strahlteiler fallende erste Strahlenbündel eine sphärische Phasenfront hat, so kann hierdurch insbesondere zylindersymmetrische, radial- oder tangential- polarisierte Strahlung erzeugt werden. Hierzu können beispielsweise Zylinderlinsen und/oder rotationssymmetrische Asphären vorgesehen sein.

Um die mit der Polarisatoreinrichtung ausgestattete optische Einrichtung wahlweise mit Polarisationsbeeinflussung oder ohne Polarisationsbeeinflussung nutzen zu können, ist bei bevorzugten Ausführungsformen vorgesehen, die Polarisationsbeeinflussungseinrichtung so auswechselbar zu machen, dass sie wahlweise in den Strahlengang eingefügt oder aus diesem entfernt werden kann. Hierzu kann eine Wechslereinrichtung vorgesehen sein, die gegebenenfalls als Teil einer Manipulationseinrichtung in diese integriert sein kann.

Um den Polarisationszustand der transmittierten Strahlungsanteile optimieren zu können, sollte der s/p-Strahlteiler verkippbar und/oder relativ zur optischen Achse verschiebbar angeordnet sein, um den Punkt auf den Strahlung senkrecht trifft und somit keine Polarisationswirkung zu erwarten ist, innerhalb der Pupille verschieben zu können.

Der s/p-Strahlteiler kann so gestaltet sein, dass die Verteilung der Polarisation der austretenden Strahlung ausschließlich durch die Eigenschaften der winkelselektiv wirksamen, die Polarisation beeinflussenden Schichten bestimmt wird, um beispielsweise radiale oder tangentiale Polarisation einzustellen. Es ist jedoch auch möglich die Polarisationsverteilung durch mindestens eine weitere die Polarisation beeinflussende Einrichtung zu modifizieren. Beispielsweise kann ein Polarisationsrotator vorgesehen sein, um die hinter dem s/p-Strahlteiler vorliegenden Polarisationsvorzugsrichtungen zu drehen. So kann ein Rotator, der zu einer Rotation um 90˚ führt, eine radial-polarisierte Verteilung in eine tangential-polarisierte Verteilung (oder umgekehrt) überführen. Als Polarisationsrotator kann beispielsweise eine Platte aus einem optisch aktiven Material genutzt werden, die hinter dem s/p-Strahlteiler angeordnet wird und auswechselbar sein kann.

Das hier an wenigen Beispielen erläuterte Prinzip besteht bei den Ausführungsformen darin, eine gewünschte Verteilung der linearen Polarisation in der Pupille in eine Winkelverteilung umzusetzen und diese dann durch eine polarisationsverändernden Schicht, insbesondere eine s/p-Strahlteilerschicht, in eine Polarisationsverteilung zu transformieren.

Die Symmetrie der Winkelverteilung bestimmt dann die Symmetrie der Polarisationsverteilung.

In einer weiteren nicht beanspruchten Ausgestaltung wird der s/p-Strahlteiler an einer Stelle im Strahlengang angeordnet, an der ohnehin eine hohe numerische Apertur vorliegt, wie beispielsweise zwischen Objekt und Mikroskopobjektiv oder zwischen Kondensor und Objekt.

Die Anordnung des s/p-Strahlteilers außerhalb eines Fokus hat außerdem den Vorteil, dass die verschiedenen Pupillenorte nicht nur durch verschiedene Einfallswinkel, sondern auch durch verschiedene Abstände zur optischen Achse gekennzeichnet sind. Eine gezielte Beeinflussung der Strahlen kann dadurch erfolgen, dass die Strahlteilerschicht über die Fläche variiert.

Außerdem ist es vorteilhaft den s/p-Strahlteiler statt auf eine plane auf eine konvex oder konkav gewölbte optische Fläche, wie beispielsweise eine pupillennahe Linsenoberfläche des Objektives oder Kondensors, aufzubringen. Zum einen kann auf die Bildung einer hohen numerischen Apertur verzichtet werden und zum anderen kann die Wölbung ausgenutzt werden, um beispielsweise eine inhomogene Strahlteilerschicht aufzubringen.

Das in einer zweiten Ausführungsform beschriebene polarisationswirksame optische Bauelement dient der Erzeugung s-polarisierter Strahlungsanteile aus p-polarisierter Strahlung oder umgekehrt. Das vorzugsweise aus einer Planplatte aus optisch aktivem Material bestehende polarisationswirksame optische Bauelement wird im Abbildungsstrahlengang angeordnet und erzeugt in Abhängigkeit seiner Dicke eine ganzzahlige Drehung der Polarisationsrichtung um (2n+1)*90°.

Für die beschriebenen Lösungen ist es meist erforderlich s- und p-polarisierte Strahlungsanteile separat zu erzeugen. Während sich die p-polarisierten Strahlungsanteile wesentlich einfacher und mit höherem Polarisationsgrad erzeugen lassen, werden für viele Anwendungen aber gerade s-polarisierte Strahlungsanteile benötigt.

Mit dem beschriebenen polarisationswirksamen optischen Bauelement werden p-polarisierte in s-polarisierte Strahlungsanteile umgewandelt. Dazu wird hinter einem p-Polarisator eine Planplatte aus optisch aktivem Material angeordnet, bei der in Abhängigkeit von dessen Dicke eine Drehung der Polarisationsrichtung erfolgt. Diese zum Beispiel aus optisch aktivem Quarz bestehende Planplatte wird so bemessen, das eine ganzzahlige Drehung der Polarisationsrichtung um (2n+1)*90° erfolgt. Die Drehrichtung ist hierbei unerheblich.

Um aus unpolarisierter Strahlung den s-polarisierten Strahlungsanteil zu selektieren, ordnet man einen p-Polarisator zwischen zwei eben beschriebenen optisch aktiven Planplatten an. Die erste Planplatte vertauscht die s- und p-polarisierten Strahlungsanteile, der p-Polarisator transmittiert die p-polarisierten Strahlungsanteile und die zweite Planplatte konvertiert die p- in s-polarisierte Strahlungsanteile. Im Unterschied zu einem s-Polarisator kann der Polarisationsgrad wesentlich verbessert werden. Grundsätzlich sind die beiden beschriebenen Anordnungen auch umgekehrt, d. h. zur Erzeugung von p-polarisierten Strahlungsanteilen verwendbar.

Optisches Bauelement mit polarisationsabhängiger Intensitätsschwächungsfunktion

Nun wird auf das optische Bauelement mit polarisationsabhängiger Intensitätsschwächungsfunktion näher eingegangen, welches in der Pupillenebene der Abbildungsoptik oder zumindest pupillennah angeordnet ist. Wie bereits erwähnt erfolgt die Beleuchtung und Abbildung unter den gleichen Bedingungen wie im lithographischen Scannersystem.

Während die objektseitige numerische Apertur in einem Scannersystem und einem Inspektionsmikroskop identisch sein können, unterscheidet sich die abbildungsseitige numerische Apertur (NA) beider Systeme hingegen um einen Faktor von beispielsweise 400. Ausgehend von einer objektseitigen NA von 0,35 beträgt die abbildungsseitige NA bei einem Scannersystem beispielweise 1,4 und beim Inspektionsmikroskop 0,0035. Vektoreffekte treten somit in Inspektionsmikroskopen nicht auf.

Entsprechend der klassischen Abbildungstheorie sollten die Intensitätsverläufe aufgrund der gleichen wirksamen objektseitigen numerischen Apertur ebenfalls identisch sein. Dies trifft allerdings nur für die Maxima zu; in den dazwischen liegenden Verläufen und insbesondere in den Minima sind jedoch erhebliche Abweichungen zu verzeichnen. Diese Fehldarstellungen ergeben sich, wenn die Wirkungen einer Lithographiemaske mit Hilfe eines Inspektionsmikroskops untersucht werden.

Sich stetig verringernde Objektstrukturgrößen erfordern Abbildungssysteme mit immer höherer abbildungsseitiger NA. Die aufgrund der großen Winkel bei der Abbildung auftretenden Vektoreffekte führen zu den Fehldarstellungen bei der Simulation von Scannersystemen mit Hilfe von Inspektionsmikroskopen.

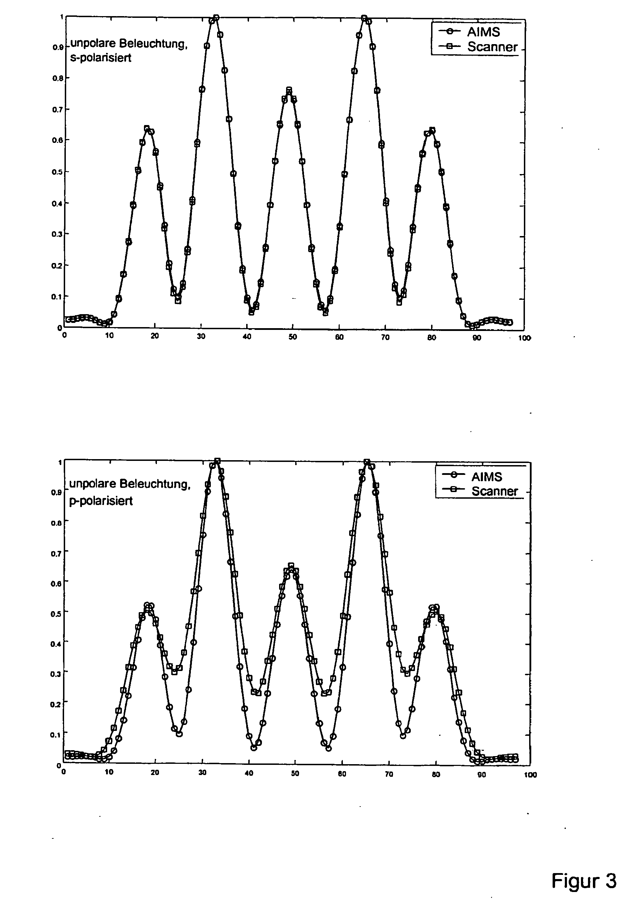

Dazu zeigt **Figur 3** die normierten Intensitätsverläufe der s- und p-polarisierten Strahlungsanteile in einem Scannersystem und einem Inspektionsmikroskop. Während sich die normierten Intensitätsverläufe der s-polarisierten Strahlungsanteile noch decken, weisen die p-polarisierten Strahlungsanteile erhebliche Abweichungen auf. Es ist erkennbar, dass die Vektoreffekte zu einem Kontrastverlust bzw. zu einem Auflösungsverlust führen.

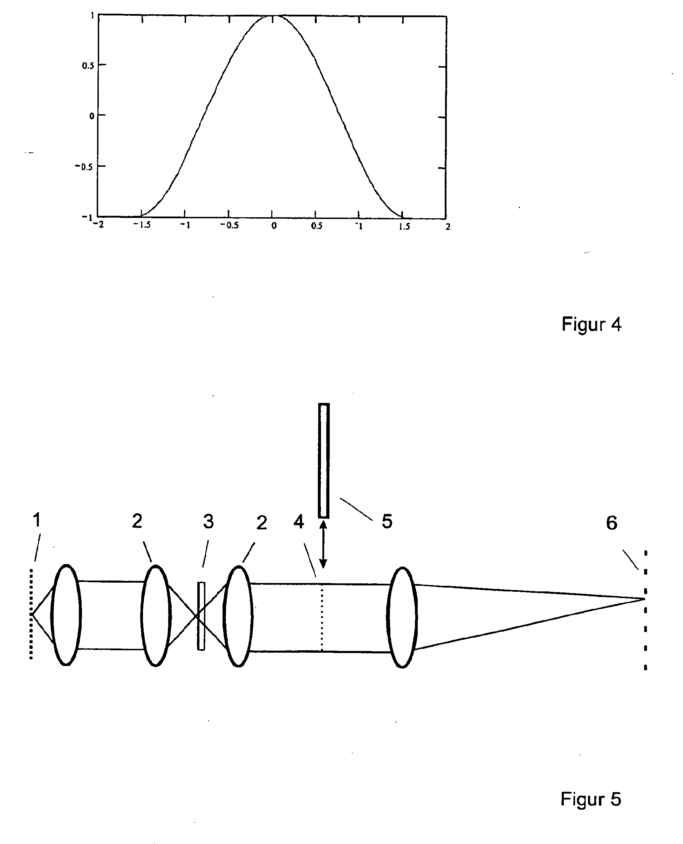

Die aus der abbildungsseitig hohen NA resultierenden großen Auftreffwinkel im Scannersystem führen durch die Vektoreffekte zu einer winkelabhängigen Wichtung der zur Bilderzeugung beitragenden Strahlenanteile. In **Figur 4** ist dazu der Verlauf einer winkelabhängigen Wichtung dargestellt, die in erster Näherung als Funktion $\cos 2\vartheta$ beschrieben werden kann, wobei $\vartheta$ dem halben Öffnungswinkel des Abbildungsobjektives des Scannersystems entspricht.

Von der Maske und/oder Probe werden nacheinander zwei Abbilder aufgenommen. Während für das erste Abbild ein p-Polarisator zusammen mit dem optischen Bauelement mit polarisationsabhängiger Intensitätsschwächungsfunktion in den Abbildungsstrahlengang eingebracht wird, ist für das zweite Abbild nur ein s-Polarisator im Abbildungsstrahlengang erforderlich.

**Figur 5** zeigt dazu das Abbildungssystem eines Inspektionsmikroskops zur Untersuchung von Lithographiemasken.

Die von der Maske und/oder Probe **1** kommenden s- und p-polarisierten Strahlungsanteile werden nacheinander über eine Abbildungsoptik **2** auf einen Detektor **6** abgebildet und von einer Auswerteeinheit ausgewertet. In der Pupillenebene **4** der Abbildungsoptik **2** oder zumindest pupillennah ist ein optisches Element **5,** mit einer zur optischen Achse symmetrischen, intensitätsschwächenden Wirkung, vorhanden. Die numerische Apertur der Abbildungsoptik **2** sollte dabei größer als 0,2, insbesondere größer als 0,5 sein. Dieses optische Element **5** wird nur zur Detektion der p-polarisierten Strahlungsanteile in den Abbildungsstrahlengang eingebracht. Der Detektor **6** empfängt somit je ein Abbild der Maske und/oder Probe **1** für s-polarisierte und für p-polarisierte Strahlungsanteile. Von der Auswerteeinheit werden diese beiden Abbilder der Maske und/oder Probe **1** durch Addition der Intensitätsverteilungen zu einem Gesamtabbild verbunden. Die Abbildungsoptik **2** stellt mit der dazwischen angeordneten s/p-Strahlteilerschicht **3** einen 2-f-Aufbau dar. Die rotationssymmetrische, intensitätsschwächende Wirkung des optischen Elementes **5** entspricht dabei der aus den Vektoreffekten resultierenden, winkelabhängigen Wichtung der zur Bilderzeugung beitragenden Strahlungsteile und beträgt in guter Näherung:

$$I_{red} = I * \cos 2\vartheta$$

In einer besonders vorteilhaften Ausgestaltung ist das im Abbildungsstrahlengang angeordnete optische Element **5** so ausgebildet, dass die s-polarisierten Strahlungsanteile nicht und die p-polarisierten Strahlungsanteile entsprechend der zuvor beschriebenen Bedingung abgeschwächt werden. Vom Detektor wird nur ein Abbild der Maske und/oder Probe **1** aufgenommen, welches die simulierten Vektoreffekten für die p-polarisierten Strahlungsanteile enthält. Eine getrennte Beleuchtung mit s- und p-polarisierter Strahlung ist hierbei nicht erforderlich. Außerdem kann das optische Element **5** im Strahlengang verbleiben. In diesem Fall stellt das im Abbildungsstrahlengang angeordnete optische Element **5** einen partiellen Polarisator mit polarisations- und winkelabhängiger Intensitätsschwächungsfunktion dar.

Das optische Element **5** kann beispielsweise als diffraktives optisches Element ausgeführt sein. Vorteilhafter Weise sollte es zum wahlweisen Einbringen in den Strahlengang sowie drehbar und/oder entlang der optischen Achse verschiebbar ausgestaltet sein.

Um die intensitätsschwächende Wirkung des optischen Elementes 6 optimieren zu können, sollte dieses verkippbar angeordnet sein, um den Punkt auf den Strahlung senkrecht trifft und somit keine Polarisationswirkung zu erwarten ist, innerhalb der Pupille verschieben zu können.

Die vom Detektor für die Beleuchtung mit unterschiedlich polarisierter Strahlung aufgenommenen Abbilder der Maske und/oder Probe werden zur Weiterverarbeitung an die Auswerteeinheit weitergeleitet. Von der Auswerteeinheit, die beispielsweise eine Computereinheit ist, werden die für unterschiedlich polarisierte Strahlung aufgenommenen Abbilder der Maske und/oder Probe durch Addition der Intensitätsverteilungen zu einem Gesamtbild zusammenfasst.

Verfahren zur Emulation hochaperturiger Scannersysteme

Bei dem erfindungsgemäßen Verfahren zur Emulation hochaperturiger Abbildungssysteme, wie beispielsweise von Scannersystemen, in einem mikroskopischen Abbildungssystem insbesondere zur Maskeninspektion, werden die Polarisationseigenschaften der Abbilder der Maske und/oder Probe bestimmt, indem eine Anzahl unterschiedlich polarisierter Abbilder aufgenommen, daraus der Grad und die Richtung der Polarisation für alle Segmente des Abbildes ermittelt, die Abbilder einer polarisationsabhängigen Wichtung ihrer Intensitätsverteilung unterzogen und zu einem Gesamtabbild, das Informationen sowohl über die Intensität als auch die Polarisationseigenschaften enthält, zusammengefasst werden.

Dazu werden polarisationswirksame optische Bauelemente im Beleuchtungsstrahlengang und/oder im Abbildungsstrahlengang wahlweise angeordnet. Im Beleuchtungsstrahlengang dienen diese der Erzeugung unterschiedlicher Polarisationszustände der Beleuchtungsstrahlung, entsprechend den Beleuchtungs- und Abbildungsbedingungen eines lithographischen Scannersystems oder eines anderen hochaperturigen Abbildungssystems. Im Gegensatz dazu werden sie im Abbildungsstrahlengang dazu verwendet, unterschiedlich polarisierte Abbilder der Maske und/oder Probe zu erzeugen. Unterschiedlich polarisierte Abbilder der Maske kann man auch messen, indem man diese mit verschiedenen Polarisationen beleuchtet.

Ermittlung von Grad und Richtung der Polarisation

Für die Aufnahme einer Anzahl unterschiedlich polarisierter Abbilder der Maske und/oder Probe wird im Beleuchtungs- und/oder Abbildungsstrahlengang ein oder mehrere polarisationsoptische Elemente, z. B. ein linearer Polarisator drehbar angeordnet. Dieser wird in mindestens drei Winkelstellungen gedreht, damit in jeder Winkelstellung vom Detektor jeweils zumindest ein Abbild aufgenommen werden kann. Beispielsweise wird je ein Abbild für Winkelstellung des linearen Polarisators von 0˚, 45˚, 90˚ und 135˚ aufgenommen. Ein durch den Polarisator eventuell verursachter Bildversatz kann gemessen und durch justieren bzw. hard- oder softwaremäßig korrigiert werden. Um Einflüsse des Polarisators auf die Bildqualität ausgleichen zu können ist es vorteilhaft zusätzlich ein unpolarisiertes Abbild, d. h. ohne den linearen Polarisator, aufzunehmen.

Die Aufnahme der Abbilder der Maske und/oder Probe mit und ohne ein polarisationswirksames optisches Element kann dabei in unterschiedlichen Entfernung von der Fokusebene erfolgen. Während die Aufnahme des oder der Abbilder mit polarisationswirksamen optischen Elementen in der Fokusebene erfolgt wird das Abbild ohne polarisationswirksames optisches Element in mehreren Ebenen vor, und/oder in und/oder hinter der Fokusebene aufgenommen. Die dabei gewonnenen Abbilder mit polarisationswirksamen optischen Elementen bilden die Berechnungsgrundlage für alle Abbilder ohne polarisationswirksames optisches Element. Grad und Richtung der Polarisation ist in einem gewissen Bereich unabhängig davon, ob die Abbilder der Maske und/oder Probe vor, in oder hinter der Fokuslage gewonnen werden.

Die aus diesen Abbildern für mehrere Pixel des Detektors ermittelten Grad und Richtung der Polarisation werden vorzugsweise als Jonesvektor, Stokesvektor oder Polarisationsmatrix dargestellt.

Die Polarisationsmatrix beispielsweise ist definiert als:

$$P = \begin{bmatrix} P_{xx} & P_{xy} \\ P_{yx} & P_{yy} \end{bmatrix} = \begin{bmatrix} \left\langle \left| A_x(t) \right|^2 \right\rangle & \left\langle A_x(t) A_y^{\bullet}(t) e^{i[\Phi(t)-\Psi(t)]} \right\rangle \\ \left\langle A_x^{\bullet}(t) A_y(t) e^{-i[\Phi(t)-\Psi(t)]} \right\rangle & \left\langle \left| A_y(t) \right|^2 \right\rangle \end{bmatrix}$$

Diese aus vier Elementen bestehende Polarisationsmatrix bildet die Grundlage für die Emulierung von Vektoreffekten im AIMS. Im Folgenden wird auf verschiedene Methoden der polarisationsabhängigen Wichtung der Intensitätsverteilungen der Abbilder (Emulierung von Vektoreffekten) eingegangen.

In einer vorteilhaften Ausgestaltung kann auf die Bestimmung der Polarisationseigenschaften des Abbildes und die Ermittlung von Grad und Richtung der Polarisation für verschiedene Pixel des Detektors unter der Annahme, dass die Polarisationseigenschaften des Abbildes denen der Beleuchtung entsprechen; verzichtet werden. Die Polarisationseigenschaften der Beleuchtung müssen dazu allerdings bekannt sein. Insbesondere für einfache Maskenstrukturen liefert diese Vereinfachung eine ausreichende Genauigkeit.

Schiebemethode

Kontrast im Bild entsteht durch die Interferenz mindestens zweier Beugungsordnungen, deren Einfallswinkel in x-Richtung $\vartheta_x$ und in y-Richtung $\vartheta_y$ ist. Für x-polarisiertes Licht ist ausgehend von den zu emulierenden Vektoreffekten in der Pupille des Inspektionsmikroskops eine Phasenverzögerung von $\eta = +\vartheta_x$ oder $-\vartheta_x$ zu erzeugen:

$$I_{x+} = E_0^2 + E_1^2 + E_0 E_1 \cos(\varphi + \Delta\vartheta_x)$$

und

$$I_{x-} = E_0^2 + E_1^2 + E_0 E_1 \cos(\varphi - \Delta\vartheta_x)$$

mit $\varphi$ = Phasendifferenz zwischen $E_0$ und $E_1$. Dieses entspricht in hinreichender Näherung einer Verschiebung des Bildes um eine bestimmte Strecke D in +/-x-Richtung.

Durch Addition der beiden Bilder und Division durch 2 erhält man :

$$I = (I_{x+} + I_{x-}) / 2 = E_0^2 + E_1^2 + E_0 E_1 \cos \varphi \; \cos \Delta\vartheta_x .$$

Die gewichtete Intensitätsverteilung $I_x$ emuliert die beschriebenen Vektoreffekte in ausreichender Näherung.

Ein partiell polarisierter Zustand kann als inkohärente Summe von zwei orthogonalen Polarisationszuständen beschrieben werden. Demnach wird auch die Intensitätsfunktion für jedes Pixel des Detektors in ein erstes Abbild, dessen Feldvektor E parallel zur Polarisationsrichtung verläuft und ein zweites Abbild, dessen Feldvektor E senkrecht dazu verläuft, aufgeteilt. Die Bedingungen für die beiden Feldvektoren lauten:

E parallel zur Polarisationsrichtung: $\quad I_{\parallel} = (1+g) / 2 * I_{ges}$
E senkrecht zur Polarisationsrichtung: $\quad I_{\perp} = (1-g) / 2 * I_{ges}$

wobei g den Polarisationsgrad definiert.

Bei dieser Methode wird das Abbild polarisationsabhängig einer Wichtung ihrer Intensitätsverteilung unterzogen, indem der Anteil $I_{\parallel}$ vom Abbild der Maske und/oder Probe als Intensitätsfunktion in Richtung der ermittelten Polarisationsrichtung um einen Betrag $\pm$ D verschoben wird. Entsprechend wird der Anteil $I_{\perp}$ vom Abbild der Maske und/ oder Probe senkrecht zur Richtung der ermittelten Polarisationsrichtung um einen Betrag $\pm$D verschoben und diese 4 Intensitätswerte addiert. Die Aufteilung in verschiedene Anteile der Intensität des Abbildes erfolgt dabei polarisationsabhängig im Verhältnis 1+g zu 1-g, wobei g der lineare Polarisationsgrad ist.

Vorzugsweise werden dabei mindestens 2 Anteile der Intensität in verschiedenen Richtungen verschoben, wobei die Schieberichtungen mindestens teilweise parallel und/oder senkrecht zur Richtung der Polarisation liegen.

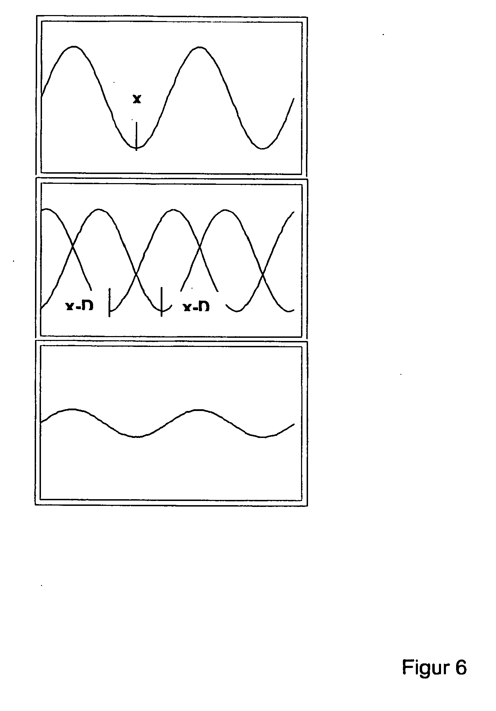

**Figur 6** zeigt dazu ein Schema zur Verdeutlichung der Addition der um den Betrag D verschobener Abbilder. Hierbei wird durch Verschieben eines Abbildes und anschließendem Addieren der Abbilder ein durch den Vektoreffekt verursachter Kontrastverlust emuliert.

Die Abbilder werden polarisationsabhängig einer Wichtung ihrer Intensitätsverteilung unterzogen, indem das Abbild der Maske und/oder Probe als Intensitätsfunktion zum einen in Richtung der ermittelten Polarisationsrichtung um einen Betrag $\pm$ D und zum anderen senkrecht zur ermittelten Polarisationsrichtung um einen Betrag $\pm$ D verschoben werden.

Der Betrag D kann z. B. als

$$D = \frac{\lambda}{n_{Lack}\, 4\sqrt{2}} \cdot \frac{c \cdot NA / n_{Lack} \big/ \arcsin(c \cdot NA / n_{Lack})}{1/\sqrt{2} \big/ \arcsin(1/\sqrt{2})}$$

gewählt werden, wobei c eine Konstante $\leq$ 1 ist, z. B. c = 0,9. Dies gilt für das zu emulierende Abbildungssystem. Im Inspektionsmikroskop muss D noch mit dem Verhältnis der Vergrößerungsfaktoren der beiden Systeme skaliert werden.

Betrachten wir z. B. ein Pixel des Detektors am Ort (x, y), an dem das Abbild mit einem linearen Polarisationsgrad von g in x-Richtung polarisiert ist. So ergibt sich das korrigierte Bild zu

$$I_{korrigiert} = \frac{I(x+D, y) + I(x-D, y)}{2} \cdot \frac{1+g}{2} + \frac{I(x, y+D) + I(x, y-D)}{2} \cdot \frac{1-g}{2} .$$

Für Polarisationsrichtungen, die nicht parallel zur x- und y-Achse liegen, berechnet sich die Schieberichtung entsprechend.

Betrachten wir z. B. ein Pixel des Detektors am Ort (x, y), an dem das Abbild mit einem linearen Polarisationsgrad von g in Richtung $\varphi$ polarisiert ist. So ergibt sich das korrigierte Bild zu:

$$I_{korrigiert} = \frac{1+g}{2} \cdot \frac{I(x + D\cos(\varphi), y + D\sin(\varphi)) + I(x - D\cos(\varphi), y - D\sin(\varphi))}{2}$$
$$+ \frac{1-g}{2} \cdot \frac{I(x - D\sin(\varphi), y + D\cos(\varphi)) + I(x + D\sin(\varphi), y - D\cos(\varphi))}{2} \quad.$$

Die Abbilder der Maske und/oder Probe bei den Positionen (x+D, y), (x-D, y), (x, y+D) und (x, y-D) werden gewichtet oder ungewichtet addiert, wobei x und y zwei bestimmte oder beliebige zueinander orthogonale Richtungen sind.

Für eine Polarisationsrichtung, die nicht parallel zu den Koordinatenachsen liegt, ergibt sich die Schieberichtung entsprechend. Wenn sich der Polarisationszustand über das Bild ändert, ändern sich auch die Schieberichtungen über das Bildfeld. Damit werden die Vektoreffekte in hinreichender Genauigkeit emuliert.

Um Einflüsse des Polarisators auf die Bildqualität auszuschließen, kann man die Intensität aus einem Abbild, das ohne Polarisator aufgenommen wurde entnehmen. Die Abbilder mit Polarisator dienen dann zur Ermittlung der Polarisationseigenschaften.

Die Polarisationseigenschaften können auch in einer anderen Ebene gemessen werden, als die Intensität. Beispielsweise kann man die Polarisationseigenschaften in der Fokusebene messen und die unpolarisierte Intensität in mehreren Ebenen vor, in und hinter der Fokusebene.

Nimmt man Einschränkungen der Genauigkeit in Kauf, kann die Polarisationsmessung durch die Annahme ersetzt werden, dass die Maske oder Probe nicht polarisierend wirkt, also die Polarisation des Abbildes identisch mit der Polarisation der Beleuchtung und somit über das ganze Bild konstant ist.

Vektoreffekte im Fourierraum

Bei dieser ersten Methode im Fourierraum zur Emulation hochaperturiger Scannersysteme in einem mikroskopischen Abbildungssystem wird das Abbild polarisationsabhängig einer Wichtung ihrer Intensitätsverteilung unterzogen, indem für alle Elemente der Polarisationsmatrix, des Stokesvektors, des Jonesvektors, der mit unterschiedlicher Polarisation aufgenommenen Intensitäten oder sonst einer polarisationsoptischen Beschreibung des Bildes für verschiedene Pixel des Detektors, eine 2-dimensionale Fouriertransformation durchgeführt, ein polarisationsabhängiger Schwächungsfaktor eingerechnet und eine 2-dimensionale Fourierrücktransformation durchgeführt wird.

Jede Fourierkomponente entspricht dabei einer im Bild vorkommenden Ortsfrequenz. Für jede Fourierkomponente erhält man somit Grad und Richtung der linearen oder gesamten Polarisation. Die Fouriertransformierte des Bildes ist nicht identisch mit der Intensitätsverteilung in der Pupille.

Bei dieser zweiten Methode im Fourierraum zur Emulation hochaperturiger Scannersysteme in einem mikroskopischen Abbildungssystem, gibt es eine andere Harangehensweise zur Bestimmung der Pupillenverteilung d. h. der Fourier-Komponenten.

Eine schon häufiger beschriebe Methode ist die Messung der Intensitätsverteilung in der Pupille mit Hilfe einer Bertrandoptik und einer anschließenden Rekonstruktion des Bildes. Bei der Messung der Intensitätsverteilung in der Pupille erhält man keine Information über die Phasenbeziehung zwischen den einzelnen Fourier-Komponenten. Dazu kommt, das sich höhere Beugungsordnungen, die wesentlich zur Feinstrukturierung des Bildes beitragen, aufgrund ihrer geringen Intensität schlecht detektieren lassen.

Es wird daher Vorgeschlagen aus der Abbildung eine Pupillenverteilung zu rekonstruieren. Dabei ist die Pupillenrekonstruktion nicht eineindeutig d. h. verschiedene Pupillenverteilungen (Intensität und Phase) können ein und das selbe Bild erzeugen. Bei der hier beschriebenen Herangehensweise zur Berücksichtigung der Vektoreffekte wird bei nicht korrekter Pupillenverteilung die jedoch die Abbildung richtig rekonstruieren läßt, nur ein vertretbar kleiner Fehler bei der Vektoreffektberücksichtigung gemacht.

Vergleicht man die Pupillengröße mit der Fourier-Komponentenverteilung die entstehen wenn die Abbildung Fourier-transformiert wird, so liegen bei kritischen Strukturen (Strukturen an der Auflösungsgrenze) einige Fourier-Komponenten außerhalb der Pupillengröße, so dass dieser direkte Ansatz der Fouriertransformation nicht zur gewünschten Pupillenverteilung führt, da alle Fourier-Komponenten innerhalb der Pupillengröße liegen müssen. Jedoch sind diese Fourier-Komponenten als Startwerte einer rekursiven Optimierung geeignet. Bei der Optimierungsschleife werden die Fourier-Komponenten (Intensität und Phase) variiert und danach die Abbildung rekonstruiert und mit der wahren Abbildung verglichen. Liegt der Unterschied zwischen wahrer und rekonstruierter Abbildung unterhalb einer gewählten Größe kann mit der daraus ergebenden Pupillenverteilung weiter gerechnet werden. Legt man bei dieser Prozedur keine unpolarisierte Abbildung zugrunde sondern eine polarisierte können dadurch die einzelnen Polarisationszustände der Fourier-Komponenten bestimmt werden.

AIMS Bild

z.B. FFT

Pupillenrekonstruktion

Optimierung

Rekonstruktion des AIMS Bildes

Rechnerische Pupillenmodifikation

Scannerbild berechnen

Die Emulation der Vektoreffekte erfolgt nun durch einen Pupilleneingriff z. B. durch eine Multiplikation mit einem ortsfrequenz- und polarisationsabhängigen Schwächungsfaktor der einzelnen Fourier-Komponenten in der Pupille. Dieser Schwächungsfaktor wird unter anderem vom Winkel zwischen Ortsfrequenzvektor und Polarisationsrichtung bestimmt. Anschließend wird mit dieser modifizierten Pupillenverteilung eine neue Abbildung rekonstruiert.

Als eine weitere Möglichkeit ist die Wichtung nicht durch eine Multiplikation mit einer Schwächungsfunktion im Fourierraum durchzuführen, sondern diese statt dessen durch die Faltung einer geeigneten Funktion im Ortsraum zu realisieren. Die Fourierrücktransformierte der Schwächungsfunktion im Fourierraum stellt dafür eine geeignete Funktion dar.

Eine gegebene Ortsfrequenz in der Abbildung wird durch mindestens 2 Beugungsordnungen in der Pupille erzeugt. Die Beugungsordnungen an den Stellen $v_1$ und $v_2$ haben den vektoriellen Abstand $\Delta v$ und die mittlere Koordinate $v_0$. Aus der Bedingung, dass $v_1$ und $v_2$ in der Pupille liegen müssen ergibt sich ein bestimmter Bereich, in dem $v_0$ liegen kann. Dieser ist umso größer, je kleiner $\Delta v$ ist.

Für jede Ortsfrequenz bzw. Fourier-Komponente wird der durch die Vektoreffekte verursachte Kontrastverlust in Abhängigkeit von $v_o$ berechnet. Der Schwächungsfaktor wird vom Winkel zwischen Ortsfrequenzvektor und Polarisationsrichtung und/oder vom Betrag des Ortsfrequenzvektors bestimmt und ist unter anderem vom Kosinus des von den dreidimensionalen E-Feld-Vektoren im Bildraum des hochaperturigen Systems eingeschlossenen Winkels abhängig. Bei mehreren möglichen Werten des Schwächungsfaktors für verschiedene mögliche $v_o$ wird ein gewichtetes oder ungewichtetes Mittel, der Median, der Mittelwert zwischen dem kleinsten und größten Wert oder sonst ein Wert innerhalb des möglichen Schwankungsbereichs gebildet. In einer vorteilhaften Ausgestaltung wird die Gewichtungsfunktion unter Berücksichtigung vom Kohärenzgrad, Beleuchtungs-Setting und/oder der Polarisation der Beleuchtung gebildet.

Bei dieser Methode werden teilweise polarisierte Fourierkomponenten in mehrere unterschiedlich polarisierte Anteile aufgespalten und der Schwächungsfaktor für die Anteile einzeln berechnet.

Ist eine Fourierkomponente teilweise polarisiert, teilt man sie in einen polarisierten und einen unpolarisierten Anteil auf. Den unpolarisierten betrachtet man zu 50% als x- und zu 50% als y-polarisiert ohne eine Phasenbeziehung. Man kann die Fourierkomponente auch aufteilen in einen Anteil parallel zur Polarisationsrichtung mit $F_{\parallel} = (1 + g) / 2 * F_{ges}$ und einen Anteil senkrecht zur Polarisationsrichtung $F_{\perp} = (1-g) / 2 * F_{ges}$, wobei g den Polarisationsgrad definiert. Für jeden der dann vorliegenden Anteile berechnet man den entsprechenden Multiplikationsfaktor $\underline{T}$ getrennt.

In einem vorteilhaften Verfahren ermittelt man die Polarisationseigenschaften durch Aufnahme ein oder mehrerer Abbilder mit polarisationsoptischen Komponenten in Beleuchtungs- und/oder Abbildungsstrahlengang und die Intensität durch eine Aufnahme ohne polarisationsoptische Komponenten in Beleuchtungs- und/oder Abbildungsstrahlengang. Die Abbilder der Maske und/oder Probe mit und ohne ein polarisationswirksames optisches Element werden im Fourierraum miteinander verrechnet.

Die Polarisationseigenschaften können auch in einer anderen Ebene gemessen werden, als die Intensität. Beispielsweise kann man die Polarisationseigenschaften in der Fokusebene messen und die unpolarisierte Intensität in mehreren Ebenen vor, in und hinter der Fokusebene.

Ein Gesamtabbild entsteht durch eine Bildrekonstruktion, z. B. eine Fourierrücktransformation mindestens einer Komponente der polarisationsoptischen Beschreibung und/oder der Gesamtintensität.

Vektoreffekte durch Faltung mit der Differenz zweier Punktbilder

Bei dieser dritten Methode zur Emulation hochaperturiger Scannersysteme in einem mikroskopischen Abbildungssystem wird das Abbild polarisationsabhängig einer Wichtung seiner Intensitätsverteilung unterzogen, indem das Abbild der Maske und/oder Probe für jedes Pixel des Detektors einer lokalen Faltung mit einem normierten Punktbild unterzogen wird.

Die bei der Abbildung eines Punktes entstehende Intensitätsverteilung wird im folgenden als Punktbild bezeichnet. Dabei entsteht in einem abbildungsseitigen hochaperturigen System aufgrund des Vektoreffekts ein anderes Punktbild als in einem Inspektionsmikroskop.

Als normiertes Punktbild wird hierbei die Funktion bezeichnet, mit der man das Punktbild des Inspektionsmikroskops falten muss, um das Punktbild des hochaperturigen Systems zu erhalten. Dieses erhält man durch eine inverse Faltung des hochaperturigen Punktbildes mit dem Punktbild des Inspektionsmikroskops.

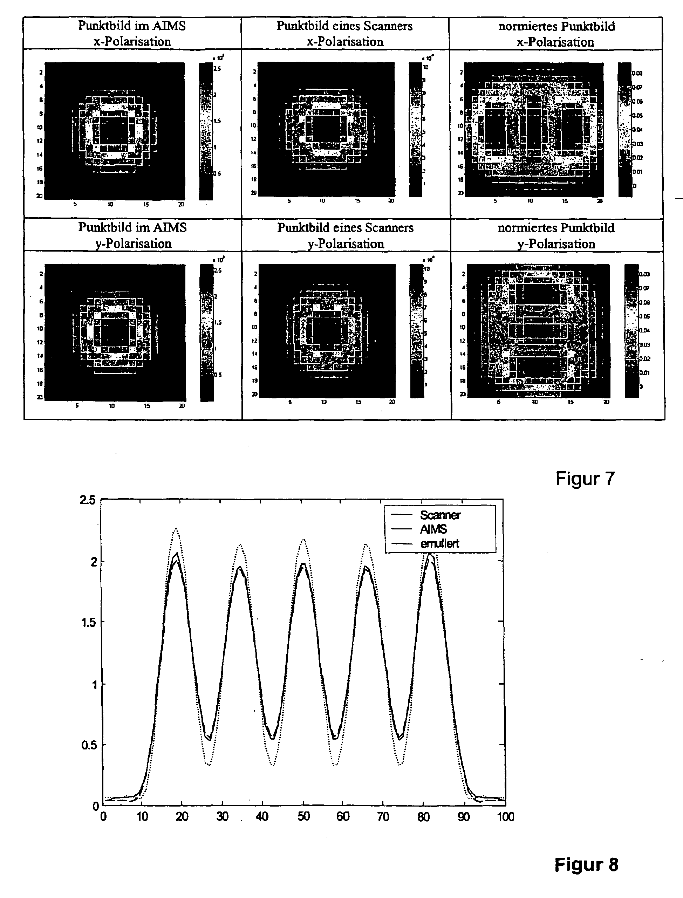

In **Figur 7** sind dazu die Punktbilder sowie die entsprechenden normierten Punktbilder für s- und p-polarisierte Strahlungsanteile dargestellt. Die lokale Faltung des Abbildes der Maske und/oder Probe mit dem normierten Punktbild erfolgt für jedes Pixel des Detektors getrennt für horizontal und vertikal polarisierte Strahlungsanteile. Statt dessen kann man die Strahlungsanteil auch aufteilen in einen Anteil, dessen E-Feld parallel zu der lokalen Polarisationsrichtung steht und einen Anteil orthogonal dazu. Die Intensitäten teilen sich dann im Verhältnis 1+g zu 1-g auf, wobei g der Polarisationsgrad ist.

Das Punktbild des Scanners wird experimentell oder theoretisch bestimmt. Es ist wünschenswert für diese Methode, dass die Punktbilder eines Scanners für alle Feldpunkte bekannt sind. Ein partiell polarisierter Zustand kann als inkohärente Summe von zwei orthogonalen Polarisationszuständen beschrieben werden. Gegeben sei in jedem Pixel die Polarisationsmatrix P(x, y)

$$
P = \begin{bmatrix} P_{xx} & P_{xy} \\ P_{yx} & P_{yy} \end{bmatrix} = \begin{bmatrix} \left\langle |A_x(t)|^2 \right\rangle & \left\langle A_x(t)A_y^*(t)e^{i[\Phi(t)-\Psi(t)]} \right\rangle \\ \left\langle A_x^*(t)A_y(t)e^{-i[\Phi(t)-\Psi(t)]} \right\rangle & \left\langle |A_y(t)|^2 \right\rangle \end{bmatrix}
$$

mit dem zugehörigen Polarisationsgrad

$$
g(x,y) = \sqrt{1 - \frac{4\det \mathbf{P}(x,y)}{\mathrm{Sp}^2 \, \mathbf{P}(x,y)}} \; .
$$

Aus der gegebenen Polarisationsmatrix kann der polarisierte Anteil

$$
\mathbf{P}^{pol}(x,y) = \mathbf{P}(x,y) - \frac{\mathrm{Sp} \, \mathbf{P}(x,y)}{2}(1 - g(x,y))\mathbf{I}
$$

errechnet werden, der das Feld $E_1(x, y)$

$$
\vec{\mathrm{E}}_1(x,y) = \begin{pmatrix} E_x \\ E_y \end{pmatrix} = \begin{pmatrix} \sqrt{P_{xx}^{pol}}\, e^{-i\psi/2} \\ \sqrt{P_{yy}^{pol}}\, e^{i\psi/2} \end{pmatrix}
$$

und das dazu orthogonale Feld $E_2(x, y)$

$$\vec{E}_2(x,y) = \begin{pmatrix} -E_y^\bullet \\ E_x^\bullet \end{pmatrix} = \begin{pmatrix} -\sqrt{P_{yy}^{pol}}\, e^{-i\psi/2} \\ \sqrt{P_{xx}^{pol}}\, e^{i\psi/2} \end{pmatrix}$$

mit dem Phasenwinkel

$$\psi(x,y) = \arg\left(P_{xy}^{pol}\right)$$

und den Matrix-Elementen

$$P_{xx}^{pol} = P_{xx} - \frac{P_{xx} + P_{yy}}{2}(1-g) = \frac{P_{xx}}{2}(g+1) + \frac{P_{yy}}{2}(g-1)$$

$$P_{yy}^{pol} = P_{yy} - \frac{P_{xx} + P_{yy}}{2}(1-g) = \frac{P_{xx}}{2}(g-1) + \frac{P_{yy}}{2}(g+1)$$

$$P_{xy}^{pol} = P_{xy}$$

liefert.

Während im vollständig polarisierten Fall $|E_2|=0$ ist, gilt im vollständig unpolarisierten Fall die Bedingung $|E_1|=|E_2|$. Im partiell polarisierten Fall beträgt das Verhältnis der Intensitäten von $E_1$ und $E_2$

$$\frac{I_2}{I_1} = \frac{1-g}{1+g}$$

Der durch die Polarisationsmatrix P beschriebene Polarisationszustand setzt sich also aus

$$\sqrt{\frac{1+g}{2}}$$

aus $\vec{E}_1$
und

$$\sqrt{\frac{1-g}{2}}$$

aus $\vec{E}_2$
zusammen. Damit setzt sich auch das Punktbild eines Scanners aus diesen Teilen der Punktbilder der beiden orthogonalen Anteile zusammen.

Entsprechend den bereits beschriebenen Methoden erfolgt hierbei die Faltung des Abbildes der Maske und/oder Probe für mehrere Pixel des Detektors mit dem normierten Punktbild ebenfalls für verschieden polarisierte Strahlungsanteile getrennt. Die Faltung erfolgt z. B. für zwei Anteile der Intensität des Abbildes, wobei die Aufteilung in die verschiedenen Anteile polarisationsabhängig erfolgt und ein Anteil mindestens teilweise parallel und/oder senkrecht zur Richtung der Polarisation liegt.

Die Abbilder werden polarisationsabhängig einer Wichtung ihrer Intensitätsverteilung unterzogen, indem das Abbild der Maske und/oder Probe als Intensitätsfunktion zum einen in Richtung der ermittelten Polarisationsrichtung um einen Betrag $\pm$ D und zum anderen senkrecht zur ermittelten Polarisationsrichtung um einen Betrag $\pm$ D gefaltet werden, wobei der Betrag D z. B. der Bedingung

$$D = \frac{\lambda}{n_{Lack}\, 4\sqrt{2}} \cdot \frac{NA/n_{Lack}\Big/\arcsin(NA/n_{Lack})}{1/\sqrt{2}\Big/\arcsin(1/\sqrt{2})}$$

mit c = Konstante $\leq$ 1, entspricht.

Die erhaltenen Abbilder der Maske und/oder Probe bei den Positionen (x+D, y), (x-D, y), (x, y+D) und (x, y-D) werden gewichtet oder ungewichtet addiert, wobei x und y zwei bestimmte oder beliebige zueinander orthogonale Richtungen sind.

Von der Auswerteeinheit werden die Abbilder für unterschiedlich polarisierte Strahlungsanteile durch Addition der Intensitätsverteilungen zu einem Gesamtbild zusammengefasst. Abbilder für unterschiedlich polarisierte Strahlungsanteile können zuvor einer Wichtung der Intensitätsverteilung unterzogen worden sein.

Die Auswertung der Abbilder erfolgt unter Berücksichtigung der Polarisationseigenschaften, so dass Vektoreffekte mindestens teilweise berücksichtigt sind.

Mit der erfindungsgemäßen Lösung ist es möglich Lithographiemasken, trotz immer kleiner werdender Strukturen und immer höheren numerischen Aperturen der Abbildungssysteme, mit Hilfe von Inspektionsmikroskopen mit großen Vergrößerungen auf Defekte zu untersuchen. Trotz auftretender Vektoreffekte können reale Abbildungen der Scannersysteme durch Emulation erzeugt werden.

Mit dem vorgeschlagenen mikroskopischen Abbildungssystem können selbst Scannersysteme, die beispielsweise Immersionsoptiken verwenden und somit eine beliebige abbildungsseitige NA von z. B. 1,6 erreichen, emuliert werden.

Eine Verwendung der erfinderischen Lösung innerhalb eines Mikroskops ist ebenfalls möglich. Beispielsweise können die Einkoppeleinrichtung und die Auskoppeleinrichtung so ausgelegt sein, dass sie innerhalb einer Tubuslinse eines Mikroskops eingebaut werden können oder als Tubuslinse dienen können. Die Polarisationsbeeinflussungseinrichtung kann dann im Bereich eines Zwischenbildes innerhalb der Tubuslinse vorgesehen sein. Die Polarisationsbeeinflussungseinrichtung sollte auswechselbar sein, um verschiedene Polarisationszustände realisieren zu können.

**Patentansprüche**

1. Mikroskopisches Abbildungssystem zur Emulation hochaperturiger Abbildungssysteme insbesondere zur Maskeninspektion, bestehend aus einer Abbildungsoptik (2), einem Detektor (6) und einer Auswerteeinheit, bei dem mindestens ein polarisationswirksames optisches Bauelemente im Beleuchtungsstrahlengang zur Erzeugung bestimmter Polarisationszustände der Beleuchtungsstrahlung und/oder im Abbildungsstrahlengang zur Selektion bestimmter Polarisationsanteile der Abbildungsstrahlung wahlweise angeordnet ist, ein optisches Bauelement mit polarisationsabhängiger Intensitätsschwächungsfunktion (5) in den Abbildungsstrahlengang eingebracht werden kann, Abbilder der Maske und/oder Probe (1) für polarisierte und/oder unpolarisierte Strahlungsanteile vom Detektor (6) aufgenommen und an die Auswerteeinheit zur Weiterverarbeitung weitergeleitet werden und

   bei dem als polarisationswirksames optisches Bauelemente eine aus zwei Linsen (21) oder Linsengruppen (2), mit mindestens einer dazwischen positionierten polarisationswirksamen Schicht (3), bestehende optische Baugruppe im Beleuchtungsstrahlung und/oder Abbildungsstrahlengang wahlweise angeordnet ist, **dadurch gekennzeichnet, dass**

   bei dem die polarisationswirksame Schicht (3) in oder zumindest in der Nähe einer der Fokusebenen von den beiden Linsen (21) oder Linsengruppen (2) angeordnet ist, wobei die Linsen (21) oder Linsengruppen (2) vorzugsweise sammelnde Brechkraft aufweisen, so dass der Polarisationsgrad von der Mitte der Pupille zum Rand hin zunimmt.

2. Mikroskopisches Abbildungssystem nach Anspruch 1, bei dem die polarisationswirksame Schicht (3) vor und/oder hinter einer der Fokusebenen von den beiden Linsen (2') oder Linsengruppen (2) angeordnet ist, so dass in der Fokusebene eine Blende angeordnet werden kann.

3. Mikroskopisches Abbildungssystem nach mindestens einem der Ansprüche 1 and 2, bei dem dem polarisationswirksamen optischen Bauelement mindestens ein weiteres polarisationsbeeinflussendes Element (5) zur Modifikation der Polarisationsverteilung zugeordnet ist.

4. Mikroskopisches Abbildungssystem nach mindestens einem der vorgenannten Ansprüche, bei dem das weitere polarisationsbeeinflussende Element ein Polarisationsrotator ist, der vorzugsweise für eine Rotation von Polarisationszuständen um 90˚ ausgelegt ist.

5. Mikroskopisches Abbildungssystem nach mindestens einem der orgenannten Ansprüche, bei dem die polarisationswirksame Schicht (3) als s/p-Strahlteiler im 2-f-Aufbau ausgeführt ist.

6. Mikroskopisches Abbildungssystem nach mindestens einem der vorgenannten Ansprüche, bei dem der s/p-Strahlteiler so ausgebildet ist, dass er in einer vorhandenen hohen numerischen Apertur angeordnet ist.

7. Mikroskopisches Abbildungssystem nach mindestens einem der vorgenannten Ansprüche, bei dem die s/p-Strahlteilerschicht auf der vorzugsweise gekrümmten Fläche einer Optik aufgebracht ist.

8. Mikroskopisches Abbildungssystem nach mindestens einem der vorgenannten Ansprüche, bei dem der s/p-Strahlteiler so ausgebildet ist, dass er wahlweise im Strahlengang angeordnet werden kann.

9. Mikroskopisches Abbildungssystem nach mindestens einem der vorgenannten Ansprüche, bei dem der s/p-Strahlteiler vorzugsweise drehbar, kippbar und/oder entlang der optischen Achse verschiebbar ausgebildet ist.

10. Mikroskopisches Abbildungssystem nach Anspruch 1, bei dem als polarisationswirksames optisches Bauelement (5) zur Erzeugung und/oder Konversion tangential-polarisierter Strahlungsanteile aus radial-polarisierten Strahlungsanteilen oder umgekehrt, eine Planplatte aus optisch aktivem Material im Abbildungsstrahlengang angeordnet ist, die z. B. in Abhängigkeit ihrer Dicke eine ganzzahlige Drehung der Polarisationsrichtung um (2n+1)*90˚ erzeugt.

11. Mikroskopisches Abbildungssystem nach Anspruch 1, bei dem als polarisationswirksames optisches Bauelement (5) zur Erzeugung von tangentialpolarisierten Strahlungsanteilen aus unpolarisierter Strahlung im Strahlengang ein Radial-Polarisator zwischen zwei Planplatte aus optisch aktivem Material angeordnet ist, die z. B. in Abhängigkeit ihrer Dicken eine ganzzahlige Drehung der Polarisationsrichtung um (2n+1)*90˚ erzeugen

12. Mikroskopisches Abbildungssystem nach Anspruch 1, bei dem das optische Bauelement mit polarisationsabhängiger Intensitätsschwächungsfunktion (5) in der Pupillenebene der Abbildungsoptik oder zumindest pupillennah angeordnet ist.

13. Mikroskopisches Abbildungssystem nach Anspruche 11, bei dem das optische Bauelement mit Intensitätsschwächungsfunktion (5) nach der Bedingung $I_{red} = I * \cos\Delta\vartheta$ vorzugsweise $I_{red} = I * \cos2\vartheta$ nur im Strahlengang angeordnet ist, wenn ein Abbild für p-polarisierte Strahlungsanteile aufgenommen werden soll, wobei $\vartheta$ dem halben Öffnungswinkel des Abbildungsobjectives des Scannersystems entspricht.

14. Mikroskopisches Abbildungssystem nach Anspruche 11 bei dem das optische Bauelement mit Intensitätsschwächungsfunktion (5) so ausgebildet ist, das es Strahlungsanteile eines Polarisationszustandes des Beleuchtungslichtes nicht und einen anderen entsprechend der Bedingung $I_{red} = I * \cos2\vartheta$ beeinflusst, so dass es z. B. ständig im Strahlengang angeordnet sein kann, wobei $\vartheta$ dem halben Öffnungswinkel des Abbildungsobjektives des Scannersystems entspricht.

15. Mikroskopisches Abbildungssystem nach Anspruch 1, bei dem die Auswerteeinheit Abbilder der Maske und/oder Probe für unterschiedlich polarisierte Strahlungsanteile durch Addition der Intensitätsverteilungen zu einem Gesamtbild zusammenfasst.

16. Verfahren zur Emulation hochaperturiger Abbildungssysteme insbesondere zur Maskeninspektion, bestehend aus einer Abbildungsoptik (2), einem Detektor (6) und einer Auswerteeinheit, bei dem im Beleuchtungsstrahlengang und/oder im Abbildungsstrahlengang unterschiedliche Polarisationszustände der Beleuchtungs- und/oder Abbildungsstrahlung wahlweise erzeugt werden können, die Polarisationseigenschaften des Abbildes bestimmt werden, indem mindestens ein Abbild der Maske und/oder Probe (1) von einem Detektor (6) aufgenommen wird, das mit oder ohne ein polarisationsoptisches Element im Beleuchtungs- und/oder Abbildungsstrahlengang gemacht wurde, **dadurch gekennzeichnet dass**, daraus der Grad und die Richtung der Polarisation für verschiedene Pixel des Detektors (6) ermittelt, die Abbilder einer polarisationsabhängigen Wichtung ihrer Intensitätsverteilung unterzogen und zu einem Gesamtabbild zusammengefasst werden.

17. Verfahren zur Emulation nach Anspruch 16, bei dem eine Anzahl von Abbildern der Maske und/oder Probe (1) aufgenommen werden, während ein im Beleuchtungs- und/oder Abbildungsstrahlengang angeordneter linearer Polarisator (5) stufenweise gedreht wird.

18. Verfahren zur Emulation nach mindestens einem der Ansprüche 16 und 17, bei dem jeweils mindestens ein Abbild der Maske und/oder Probe (1) für mindestens drei Winkelstellungen eines polarisationswirksamen optischen Elements (5) aufgenommen wird.

19. Verfahren zur Emulation nach mindestens einem der Ansprüche 16 bis 18, bei dem zusätzlich oder statt dessen ein unpolarisiertes Abbild der Maske und/oder Probe (1) aufgenommen wird.

20. Verfahren zur Emulation nach mindestens einem der Ansprüche 16 bis 19, bei dem die Abbilder der Maske und/oder Probe (1) mit und ohne ein im Beleuchtungs- und/oder Abbildungsstrahlengang angeordnetes polarisationswirksames optisches Element (5), in unterschiedlichen Entfernung von der Fokusebene aufgenommen werden.

21. Verfahren zur Emulation nach Anspruch 20, bei dem das oder die Abbilder mit polarisationswirksamen optischen Elementen vor, in oder hinter der Fokusebene und das Abbild ohne polarisationswirksames optisches Element (5) in mehreren Ebenen vor und/oder in und/oder hinter der Fokusebene aufgenommen werden.

22. Verfahren zur Emulation nach mindestens einem der Ansprüche 16 bis 21, bei dem Grad und Richtung der Polarisation für mehrere Pixel des Detektors (6) als Polarisationsmatrix, Jonesmatrix, Jonesvektor oder eine andere polarisationsoptische Beschreibung beschrieben wird.

23. Verfahren zur Emulation nach Anspruch 16, bei dem auf die Bestimmung der Polarisationseigenschaften des Abbildes und die Ermittlung von Grad und Richtung der Polarisation für verschiedene Pixel des Detektors (6) unter der Annahme, dass die Polarisationseigenschaften des Abbildes denen der Beleuchtung entsprechen, verzichtet werden kann.

24. Verfahren zur Emulation nach mindestens einem der Ansprüche 16 bis 23, bei dem die Abbilder polarisationsabhängig einer Wichtung ihrer Intensitätsverteilung unterzogen werden, indem Anteile der Intensität des Abbildes der Maske und/oder Probe (1) als Intensitätsfunktion in verschiedenen Richtungen um einen bestimmten Betrag verschoben werden, wobei die Aufteilung in die verschiedenen Anteile polarisationsabhängig erfolgt.

25. Verfahren zur Emulation nach Anspruch 24, bei dem mindestens 2 Anteile der Intensität in verschiedenen Richtungen verschoben werden, wobei die Schieberichtungen mindestens teilweise parallel und/oder senkrecht zur Richtung der Polarisation liegen.

26. Verfahren zur Emulation nach mindestens einem der Ansprüche 24 bis 25, bei dem die Aufteilung in die verschiedenen Anteile im Verhältnis 1 +g zu 1-g erfolgt, wobei g der lineare Polarisationsgrad ist.

27. Verfahren zur Emulation nach mindestens einem der Ansprüche 24 bis 26, bei dem die Abbilder polarisationsabhängig einer Wichtung ihrer Intensitätsverteilung unterzogen werden, indem das Abbild der Maske und/oder Probe (1) als Intensitätsfunktion zum einen in Richtung der ermittelten Polarisationsrichtung um einen Betrag $\pm$ D und zum anderen senkrecht zur ermittelten Polarisationsrichtung um einen Betrag $\pm$ D verschoben werden.

28. Verfahren zur Emulation nach Anspruch 27, bei dem der Betrag D z. B. der

$$\text{Bedingung}\quad D = \frac{\lambda}{n_{Lack}\,4\sqrt{2}} \cdot \frac{c \cdot NA / n_{Lack} \Big/ \arcsin(NA / n_{Lack})}{1/\sqrt{2} \Big/ \arcsin(1/\sqrt{2})}$$

entspricht, wobei mit c = Konstante $\leq$ 1 ist, NA die numerische Apertur ist, $\lambda$ die Wellenlänge kennzeichnet, und $n_{Lack}$ den Brechungsindex des Mediums in der Fokusebene in dem das Bild entsteht entspricht.

29. Verfahren zur Emulation nach mindestens einem der Ansprüche 24 bis 28, bei dem die Abbilder der Maske und/ oder Probe (1) bei den Positionen (x+D, y), (x-D, y), (x, y+D) und (x, y-D) gewichtet oder ungewichtet addiert werden wobei x und y zwei bestimmte oder beliebige zueinander orthogonale Richtungen sind.

30. Verfahren zur Emulation nach mindestens einem der Ansprüche 16 bis 23, bei dem ausgehend von der Abbildung diese Abbildung modifiziert wird, indem der Umweg über die Pupillenverteilung und/oder deren Rekonstruktion oder eine Faltung mit einem geeigneten Punktbild z. B. der Differenz des Punktbildes des Abbildungsseitigen hoch- und niederaperturigen Systems erfolgen kann.

31. Verfahren zur Emulation nach Anspruch 30, bei dem die Abbilder polarisationsabhängig einer Wichtung ihrer Intensitätsverteilung unterzogen werden, indem für alle Elemente des Jonesvektors, Stokesvektors oder der Polarisationsmatrix, der mit verschiedenen polarisationswirksamen optischen Elementen im Beleuchtungs- und/oder Abbildungsstrahlengang gemessenen Abbilder oder einer anderen polarisationsoptischen Beschreibung des Abbildes für verschiedene Pixel des Detektors eine 2-dimensionale Frequenz-Komponenten-Bestimmung durchgeführt, ein polarisationsabhängiger Schwächungsfaktor eingerechnet und eine 2-dimensionale Bildrekonstruktion durchgeführt wird.

32. Verfahren zur Emulation nach mindestens einem der Ansprüche 30 bis 31, bei dem die Wichtung statt durch eine Multiplikation mit einer Schwächungsfunktion im Frequenz-Raum durch eine Faltung einer geeigneten Funktion im Ortsraum durchgeführt wird, wobei die Transformierte der Schwächungsfunktion in den Bild-Raum eine geeignete Funktion ist.

33. Verfahren zur Emulation nach mindestens einem der Ansprüche 30 bis 32, bei dem der polarisationsabhängige Schwächungsfaktor vom Winkel zwischen Ortsfrequenzvektor und Polarisationsrichtung und/oder dem Betrag des Ortsfrequenzvektors bestimmt wird.

34. Verfahren zur Emulation nach Anspruch 33, bei dem sich der polarisationsabhängige Schwächungsfaktor unter anderem aus dem Kosinus des von den dreidimensionalen E-Feld-Vektoren im Bildraum des hochaperturigen Systems eingeschlossenen Winkels berechnet.

35. Verfahren zur Emulation nach mindestens einem der Ansprüche 30 bis 34, bei dem bei mehreren möglichen Werten des Schwächungsfaktors ein gewichtetes oder ungewichtetes Mittel, der Median, der Mittelwert zwischen dem kleinsten und größten Wert oder sonst ein Wert innerhalb des möglichen Schwankungsbereichs gebildet wird.

36. Verfahren zur Emulation nach Anspruch 35, bei dem die Gewichtungsfunktion unter Berücksichtigung der Eigenschaften und/oder der Polarisation der Beleuchtung gebildet wird.

37. Verfahren zur Emulation nach mindestens einem der Ansprüche 30 bis 36, bei dem teilweise polarisierte Frequenz-Komponenten in mehrere unterschiedlich polarisierte Anteile aufgespalten werden und der Schwächungsfaktor für die Anteile einzeln berechnet wird.

38. Verfahren zur Emulation nach Anspruch 37, bei dem diese Anteile vorzugsweise parallel und/oder senkrecht zu der Polarisationsrichtung polarisiert sind.

39. Verfahren zur Emulation nach mindestens einem der Ansprüche 30 bis 38, bei dem teilweise polarisierte Frequenz-Komponenten, in einen polarisierten und einen unpolarisierten Anteil aufteilt, den unpolarisierten Anteil zu 50% als x- und zu 50% als y-polarisiert betrachtet, wobei x und y zwei bestimmte oder beliebige zueinander orthogonale Richtungen sind und der polarisationsabhängige Schwächungsfaktor für jeden der 3 Anteile einzeln berechnet.

**40.** Verfahren zur Emulation nach mindestens einem der Ansprüche 30 bis 39, bei dem die Abbilder der Maske und/oder Probe (1) mit und ohne ein im Beleuchtungs- und/oder Abbildungsstrahlengang angeordnetes polarisationswirksames optisches Element (5) im Frequenz-Raum miteinander verrechnet werden.

**41.** Verfahren zur Emulation nach Anspruch 40, bei dem ein Gesamtabbild durch Bildrekonstruktion mindestens einer Komponente der polarisationsoptischen Beschreibung und/oder der Gesamtintensität entsteht.

**42.** Verfahren zur Emulation nach mindestens einem der Ansprüche 16 bis 23, bei dem die Abbilder polarisationsabhängig einer Wichtung ihrer Intensitätsverteilung unterzogen werden, indem das Abbild der Maske und/oder Probe für mehrere Pixel des Detektors (6) einer lokalen Faltung mit einem normierten Punktbild unterzogen wird.

**43.** Verfahren zur Emulation nach Anspruch 42, bei dem als normiertes Punktbild die inverse Faltung des hochaperturigen Punktbildes mit dem Punktbild des Inspektionsmikroskops verwendet wird.

**44.** Verfahren zur Emulation nach mindestens einem der Ansprüche 42 bis 43, bei dem die lokale Faltung des Abbildes der Maske und/oder Probe (1) für mehrere Pixel des Detektors (6) mit dem normierten Punktbild für verschieden polarisierte Strahlungsanteile getrennt erfolgt.

**45.** Verfahren zur Emulation nach mindestens einem der Ansprüche 42 bis 44, bei dem die lokale Faltung des Abbildes der Maske und/oder Probe (1) mit einem normierten Punktbild für mindestens zwei Anteile der Intensität des Abbildes erfolgt, wobei die Aufteilung in die verschiedenen Anteile polarisationsabhängig erfolgt und ein Anteil mindestens teilweise parallel und/oder senkrecht zur Richtung der Polarisation liegt.

**46.** Verfahren zur Emulation nach mindestens einem der Ansprüche 42 bis 45, bei dem die Aufteilung in die verschiedenen Anteile im Verhältnis 1 +g zu 1-g erfolgt, wobei g der lineare Polarisationsgrad ist.

**47.** Verfahren zur Emulation nach Anspruch 16, bei dem von der Auswerteeinheit Abbilder der Maske und/oder Probe (1) für unterschiedlich polarisierte Strahlungsanteile durch Addition der Intensitätsverteilungen zu einem Gesamtbild zusammengefasst werden, wobei Abbilder für unterschiedlich polarisierte Strahlungsanteile zuvor einer Wichtung der Intensitätsverteilung unterzogen worden sein können.

**48.** Verfahren zur Emulation nach Anspruch 47, bei dem die Auswertung der Abbilder unter Berücksichtigung der Polarisationseigenschaften erfolgt und Vektoreffekte mindestens teilweise berücksichtigt.

**49.** Verfahren zur Emulation nach mindestens einem der Ansprüche 30 bis 31, bei dem ein Optimierungsalgorithmus z.B. rekursiver Art zur Rekonstruktion der Pupillenverteilung dient, die dann zur Berechnung bzw. Berücksichtigung des Vektoreffekts verwendet werden kann.

**Claims**

**1.** Microscopic imaging system for emulation of high-aperture imaging systems, in particular for mask inspection, consisting of imaging optics (2), a detector (6) and an evaluating unit, wherein at least one polarising optical element is optionally disposed in the illumination beam path for generating predetermined polarisation states of the illumination radiation and/or in the imaging beam path for selecting predetermined polarisation components of the imaging radiation, an optical element having a polarisation-dependent intensity attenuation function (5) can be introduced into the imaging beam path, images of the mask and/or sample (1) for polarised and/or unpolarised radiation components are recorded by the detector (6) and are relayed to the evaluating unit for further processing, and wherein an optical assembly consisting of two lenses (2') or lens groups (2) having at least one polarising layer positioned therebetween is optionally disposed as a polarising optical element in the illumination radiation and/or imaging beam path, **characterised in that** wherein [sic] the polarising layer (3) is disposed in or at least in the vicinity of one of the focal planes of the two lenses (2') or lens groups (2), wherein the lenses (2') or lens groups (2) preferably have positive refractive power, so that the degree of polarisation increases from the centre of the pupil towards the edge.

**2.** Microscopic imaging system as claimed in claim 1, wherein the polarising layer (3) is disposed in front of and/or behind one of the focal planes of the two lenses (2') or lens groups (2), so that a diaphragm can be disposed in the focal plane.

3. Microscopic imaging system as claimed in at least one of claims 1 and 2, wherein at least one further polarisation-influencing element (5) is allocated to the polarising optical element for the purpose of modifying the polarisation distribution.

4. Microscopic imaging system as claimed in at least one of the preceding claims, wherein the further polarisation-influencing element is a polarisation rotator which is designed preferably for a 90° rotation of polarisation states.

5. Microscopic imaging system as claimed in at least one of the preceding claims, wherein the polarising layer (3) is designed as an s/p-beam splitter in a 2-f-structure.

6. Microscopic imaging system as claimed in at least one of the preceding claims, wherein the s/p-beam splitter is formed in such a manner that it is disposed in an existing high numerical aperture.

7. Microscopic imaging system as claimed in at least one of the preceding claims, wherein the s/p-beam splitter layer is applied on the preferably curved surface of optics.

8. Microscopic imaging system as claimed in at least one of the preceding claims, wherein the s/p-beam splitter is formed in such a manner that it can be disposed optionally in the beam path.

9. Microscopic imaging system as claimed in at least one of the preceding claims, wherein the s/p-beam splitter is formed so as to be preferably rotatable, tiltable and/or displaceable along the optical axis.

10. Microscopic imaging system as claimed in claim 1, wherein a plane plate consisting of optically active material is disposed in the imaging beam path as a polarising optical element (5) for generating and/or converting tangentially polarised radiation components from radially polarised radiation components or vice versa, and e.g. in dependence upon its thickness said plane plate generates an integral rotation of the polarisation direction by (2n+1)*90°.

11. Microscopic imaging system as claimed in claim 1, wherein a radial polariser is disposed in the beam path between two plane plates consisting of optically active material as a polarising optical element (5) for generating tangentially polarised radiation components from unpolarised radiation, which two plates generate, e.g. in dependence upon their thickness, an integral rotation of the polarisation direction by (2n+1)*90°.

12. Microscopic imaging system as claimed in claim 1, wherein the optical element having a polarisation-dependent intensity attenuation function (5) is disposed in the pupil plane of the imaging optics or at least near to the pupil.

13. Microscopic imaging system as claimed in claim 11, wherein the optical element having an intensity attenuation function (5) according to the condition $I_{red} = I * cos\ \Delta\vartheta$, preferably $I_{red} = I * cos\ 2\vartheta$, is only disposed in the beam path if an image is to be recorded for p-polarised radiation components, wherein 9 corresponds to half the aperture angle of the imaging objective of the scanning system.

14. Microscopic imaging system as claimed in claim 11, wherein the optical element having an intensity attenuation function (5) is formed in such a manner that it does not influence radiation components of a polarisation state of the illumination light but influences a different radiation component corresponding to the condition $I_{red} = I * cos\ 2\vartheta$, so that e.g. it can be disposed constantly in the beam path, wherein 9 corresponds to half the aperture angle of the imaging objective of the scanning system.

15. Microscopic imaging system as claimed in claim 1, wherein the evaluating unit combines images of the mask and/or sample for differently polarised beam components by adding the intensity distributions to produce a total image.

16. Method of emulation of high-aperture imaging systems, in particular for mask inspection, consisting of imaging optics (2), a detector (6) and an evaluating unit, wherein different polarisation states of the illumination radiation and/or imaging radiation can be optionally generated in the illumination beam path and/or in the imaging beam path, the polarisation characteristics of the image are determined in that at least one image of the mask and/or sample (1), which has been made with or without a polarisation-optical element in the illumination beam path and/or imaging beam path, is recorded by a detector, **characterised in that** from this the degree and the direction of polarisation is determined for various pixels of the detector (6), the images are subjected to a polarisation-dependent weighting of their intensity distribution and are combined to produce a total image.

17. Method of emulation as claimed in claim 16, wherein a number of images of the mask and/or sample (1) are recorded, while a linear polariser (5) which is disposed in the illumination beam path and/or imaging beam path is rotated stepwise.

18. Method of emulation as claimed in at least one of claims 16 and 17, wherein in each case at least one image of the mask and/or sample (1) is recorded for at least three angular positions of a polarising optical element (5).

19. Method of emulation as claimed in at least one of claims 16 to 18, wherein an unpolarised image of the mask and/or sample (1) is recorded in addition or instead.

20. Method of emulation as claimed in at least one of claims 16 to 19, wherein the images of the mask and/or sample (1) are recorded at different distances from the focal plane with and without a polarising optical element (5) which is disposed in the illumination beam path and/or imaging beam path.

21. Method of emulation as claimed in claim 20, wherein the image(s) is/are recorded with polarising optical elements in front of, in or behind the focal plane, and the image is recorded without a polarising optical element (5) in several planes in front of and/or in and/or behind the focal plane.

22. Method of emulation as claimed in at least one of claims 16 to 21, wherein the degree and direction of polarisation is described for several pixels of the detector (6) as a polarisation matrix, Jones matrix, Jones vector or other polarisation-optical description.

23. Method of emulation as claimed in claim 16, wherein the determination of the polarisation characteristics of the image and the determination of the degree and direction of polarisation for different pixels of the detector (6) can be dispensed with, assuming that the polarisation characteristics of the image correspond to those of the illumination.

24. Method of emulation as claimed in at least one of claims 16 to 23, wherein the images are subjected in a polarisation-dependent manner to a weighting of their intensity distribution, in that portions of the intensity of the image of the mask and/or sample (1) as an intensity function are displaced in different directions by a predetermined amount, wherein the division into different portions is performed in a polarisation-dependent manner.

25. Method of emulation as claimed in claim 24, wherein at least 2 portions of the intensity are displaced in different directions, wherein the displacement directions lie at least partially in parallel with and/or perpendicular to the direction of polarisation.

26. Method of emulation as claimed in at least one of claims 24 to 25, wherein the division into the different portions is performed at a ratio of 1+g to 1-g, where g is the degree of linear polarisation.

27. Method of emulation as claimed in at least one of claims 24 to 26, wherein the images are subjected in a polarisation-dependent manner to a weighting of their intensity distribution, in that the image of the mask and/or sample (1) as an intensity function is displaced on the one hand in the direction of the determined polarisation direction by an amount D and on the other hand perpendicularly with respect to the determined polarisation direction by an amount D.

28. Method of emulation as claimed in claim 27, wherein the amount D corresponds e.g. to the condition:

$$D = \frac{\lambda}{n_{Lack}\,4\sqrt{2}} \cdot \frac{c \cdot NA/n_{Lack} \big/ \arcsin(c \cdot NA/n_{Lack})}{1/\sqrt{2} \big/ \arcsin(1/\sqrt{2})}$$

where c = a constant ≤ 1, NA is the numerical aperture, $\lambda$ denotes the wavelength and slack corresponds to the refractive index of the medium in the focal plane in which the image is produced.

29. Method of emulation as claimed in at least one of claims 24 to 28, wherein the images of the mask and/or sample (1) at the positions (x+D, y), (x-D, y), (x, y+D) and (x, y-D) are added with or without weighting, wherein x and y are two predetermined directions or any mutually orthogonal directions.

**30.** Method of emulation as claimed in at least one of claims 16 to 23, wherein, starting from the image, this image is modified, in that the alternative route via pupil distribution and/or its reconstruction, or a convolution with a suitable point image e.g. the difference of the point image of the image-side high-aperture and low-aperture system can be followed.

**31.** Method of emulation as claimed in claim 30, wherein the images are subjected in a polarisation-dependent manner to a weighting of their intensity distribution, in that for all elements of the Jones vector, Stokes vector or polarisation matrix, of the images measured with different polarising optical elements in the illumination beam path and/or imaging beam path or of a different polarisation-optical description of the image for different pixels of the detector, a 2-dimensional frequency component determination is performed, a polarisation-dependent attenuation factor is calculated and a 2-dimensional image reconstruction is performed.

**32.** Method of emulation as claimed in at least one of claims 30 to 31, wherein the weighting is performed by a convolution of a suitable function in position space instead of by multiplication by an attenuation function in frequency space, wherein the transform of the attenuation function into the image space is a suitable function.

**33.** Method of emulation as claimed in at least one of claims 30 to 32, wherein the polarisation-dependent attenuation factor is determined by the angle between the spatial frequency vector and the polarisation direction and/or the value of the spatial frequency vector.

**34.** Method of emulation as claimed in claim 33, wherein the polarisation-dependent attenuation factor is calculated *inter alia* from the cosine of the angle included by the three-dimensional E-field vectors in the image space of the high-aperture system.

**35.** Method of emulation as claimed in at least one of claims 30 to 34, wherein in the case where the attenuation factor can have several possible values a weighted or unweighted average, the median, the mean value between the smallest and largest value, or otherwise a value within the possible fluctuation range is formed.

**36.** Method of emulation as claimed in claim 35, wherein the weighting function is formed taking into consideration the characteristics and/or the polarisation of the illumination.

**37.** Method of emulation as claimed in at least one of claims 30 to 36, wherein partially polarised frequency components are split up into several differently polarised portions and the attenuation factor is calculated individually for the portions.

**38.** Method of emulation as claimed in claim 37, wherein these portions are preferably polarised in parallel with and/or perpendicular to the polarisation direction.

**39.** Method of emulation as claimed in at least one of claims 30 to 38, wherein partially polarised frequency components are divided up into a polarised portion and an unpolarised portion, the unpolarised portion is considered to be 50% x-polarised and 50% y-polarised, wherein x and y are two predetermined directions or any mutually orthogonal directions and the polarisation-dependent attenuation factor is calculated individually for each of the 3 portions.

**40.** Method of emulation as claimed in at least one of claims 30 to 39, wherein the images of the mask and/or sample (1) with and without a polarising optical element (5) which is disposed in the illumination beam path and/or imaging beam path are offset against each other in frequency space.

**41.** Method of emulation as claimed in claim 40, wherein a total image is produced by means of image reconstruction of at least one component of the polarisation-optical description and/or the total intensity.

**42.** Method of emulation as claimed in at least one of claims 16 to 23, wherein the images are subjected in a polarisation-dependent manner to a weighting of their intensity distribution, in that the image of the mask and/or sample is subjected to a local convolution with a normalised point image for several pixels of the detector (6).

**43.** Method of emulation as claimed in claim 42, wherein the inverse convolution of the high-aperture point image with the point image of the inspection microscope is used as a normalised point image.

**44.** Method of emulation as claimed in at least one of claims 42 to 43, wherein the local convolution of the image of the mask and/or sample (1) is performed separately for several pixels of the detector (6) with the normalised point image for differently polarised radiation components.

45. Method of emulation as claimed in at least one of claims 42 to 44, wherein the local convolution of the image of the mask and/or sample (1) with a normalised point image is performed for at least two portions of the intensity of the image, wherein the division into the different portions is performed in a polarisation-dependent manner and a portion lies at least partially in parallel with and/or perpendicular to the direction of polarisation.

46. Method of emulation as claimed in at least one of claims 42 to 45, wherein the division into the different portions is performed at a ratio of 1+g to 1-g, wherein g is the degree of linear polarisation.

47. Method of emulation as claimed in claim 16, wherein images of the mask and/or the sample (1) are combined by the evaluating unit for differently polarised radiation portions by adding the intensity distributions to produce a total image, wherein images for differently polarised radiation portions can have been subjected to a weighting of the intensity distribution beforehand.

48. Method of emulation as claimed in claim 47, wherein the images are evaluated taking into consideration the polarisation characteristics, and vector effects are at least partially taken into consideration.

49. Method of emulation as claimed in at least one of claims 30 to 31, wherein an optimisation algorithm e.g. of a recursive type is used for the reconstruction of the pupil distribution which can then be utilised for calculating or taking into consideration the vector effect.

**Revendications**

1. Système de reproduction microscopique pour émuler des systèmes de reproduction à haute ouverture, en particulier pour le contrôle de masque, composé d'un élément optique de reproduction (2), d'un détecteur (6) et d'une unité d'évaluation, dans lequel au moins un composant optique à effet de polarisation est disposé au choix sur la trajectoire de rayon d'éclairage pour générer certains états de polarisation du rayonnement d'éclairage et/ou sur la trajectoire de rayon de reproduction pour sélectionner certaines fractions de polarisation du rayonnement de reproduction, un composant optique avec une fonction d'affaiblissement d'intensité (5) en fonction de la polarisation peut être introduit dans la trajectoire de rayon de reproduction, des reproductions du masque et/ou de l'échantillon (1) sont enregistrées par le détecteur (6) pour des fractions de rayonnement polarisées et/ou non polarisées et sont retransmises à l'unité d'évaluation pour un traitement ultérieur, et dans lequel en tant que composant optique à effet de polarisation, un sous-ensemble optique composé de deux lentilles (21) ou groupes de lentilles (2), avec au moins une couche à effet de polarisation (3) positionnée entre ceux-ci, est disposé au choix sur la trajectoire de rayon d'éclairage et/ou la trajectoire de rayon de reproduction, **caractérisé en ce que** la couche à effet de polarisation (3) est disposée dans ou du moins à côté d'un des plans focaux des deux lentilles (21) ou groupes de lentilles (2), les lentilles (21) ou groupes de lentilles (2) présentant de préférence un pouvoir réfringent convexe de sorte que le degré de polarisation augmente du centre de la pupille vers le bord.

2. Système de reproduction microscopique selon la revendication 1, dans lequel la couche à effet de polarisation (3) est disposée devant et/ou derrière l'un des plans focaux des deux lentilles (21) ou groupes de lentilles (2) de sorte qu'un filtre peut être disposé dans le plan focal.

3. Système de reproduction microscopique selon au moins l'une quelconque des revendications 1 et 2, dans lequel le composant optique à effet de polarisation se voit attribuer au moins un autre élément affectant la polarisation (5) pour modifier la distribution de polarisation.

4. Système de reproduction microscopique selon au moins l'une quelconque des revendications précédentes, dans lequel l'autre élément affectant la polarisation est un rotateur de polarisation qui est de préférence conçu pour une rotation de 90˚ des états de polarisation.

5. Système de reproduction microscopique selon au moins l'une quelconque des revendications précédentes, dans lequel la couche à effet de polarisation (3) est réalisée comme un séparateur de rayon s/p à structure 2-f.

6. Système de reproduction microscopique selon au moins l'une quelconque des revendications précédentes, dans lequel le séparateur de rayon s/p est réalisé de telle sorte qu'il est disposé dans une haute ouverture numérique existante.

**7.** Système de reproduction microscopique selon au moins l'une quelconque des revendications précédentes, dans lequel la couche de séparateur de rayon s/p est appliquée à la surface de préférence courbée d'un élément optique.

**8.** Système de reproduction microscopique selon au moins l'une quelconque des revendications précédentes, dans lequel le séparateur de rayon s/p est réalisé de telle sorte qu'il peut être disposé au choix sur la trajectoire de rayon.

**9.** Système de reproduction microscopique selon au moins l'une quelconque des revendications précédentes, dans lequel le séparateur de rayon s/p est de préférence réalisé de façon à pouvoir tourner, basculer et/ou se déplacer le long de l'axe optique.

**10.** Système de reproduction microscopique selon la revendication 1, dans lequel en tant que composant optique à effet de polarisation (5) pour générer et/ou convertir des fractions de rayonnement à polarisation tangentielle à partir de fractions de rayonnement à polarisation radiale, ou vice versa, une lame à faces planes d'un matériau optique actif est disposée sur la trajectoire de rayon de reproduction qui génère par exemple en fonction de son épaisseur une rotation de nombre entier de la direction de polarisation de $(2n+1)*90°$.

**11.** Système de reproduction microscopique selon la revendication 1, dans lequel en tant que composant optique à effet de polarisation (5) pour générer des fractions de rayonnement à polarisation tangentielle à partir d'un rayonnement, un polariseur radial est disposé sur la trajectoire de rayon entre deux lames à faces planes d'un matériau optiquement actif, qui génèrent par exemple en fonction de leur épaisseur une rotation de nombre entier de la direction de polarisation de $(2n+1)*90°$.

**12.** Système de reproduction microscopique selon la revendication 1, dans lequel le composant optique (5) avec une fonction d'affaiblissement d'intensité en fonction de la polarisation est disposé dans le plan de pupille de l'élément optique de reproduction ou du moins à proximité de la pupille.

**13.** Système de reproduction microscopique selon la revendication 11, dans lequel en tant que composant optique (5) avec une fonction d'affaiblissement d'intensité selon la condition $I_{red} = I*cos\Delta\partial$, de préférence $I_{red} = I*cos2\partial$, est disposé sur la trajectoire de rayon seulement lorsqu'une reproduction pour des fractions de rayonnement polarisées p doit être enregistrée, dans lequel $\partial$ correspond à la moitié de l'angle d'ouverture de l'objectif de reproduction du système de scanner.

**14.** Système de reproduction microscopique selon la revendication 11, dans lequel le composant optique (5) avec une fonction d'affaiblissement d'intensité est réalisé de telle sorte qu'il n'affecte pas les fractions de rayonnement d'un état de polarisation de la lumière d'éclairage, et affecte une autre fraction selon la condition $I_{red} = I*cos2\partial$, de sorte qu'il peut par exemple être disposé en permanence sur la trajectoire de rayon, où $\partial$ correspond à la moitié de l'angle d'ouverture de l'objectif de reproduction du système de scanner.

**15.** Système de reproduction microscopique selon la revendication 1, dans lequel l'unité d'évaluation regroupe des reproductions du masque et/ou de l'échantillon pour des fractions de rayonnement à différentes polarisations par l'addition des distributions d'intensité en une image globale.

**16.** Procédé d'émulation de systèmes de reproduction à haute ouverture, en particulier pour le contrôle de masque, composé d'un élément optique de reproduction (2), d'un détecteur (6) et d'une unité d'évaluation, dans lequel sur la trajectoire de rayon d'éclairage et/ou sur la trajectoire de rayon de reproduction différents états de polarisation du rayonnement d'éclairage et/ou de reproduction peuvent être générés au choix, les propriétés de polarisation de la reproduction sont déterminées en ce qu'au moins une reproduction du masque et/ou de l'échantillon (1) est enregistrée par un détecteur (6), qui a été réalisée avec ou sans élément optique de polarisation sur la trajectoire de rayon d'éclairage et/ou de reproduction, **caractérisé en ce que** le degré et la direction de la polarisation sont déterminés à partir de celle-ci pour différents pixels du détecteur (6), les reproductions sont soumises à une pondération en fonction de la polarisation de leur distribution d'intensité et regroupées en une image globale.

**17.** Procédé d'émulation selon la revendication 16, dans lequel un certain nombre de reproductions du masque et/ou de l'échantillon (1) est enregistré alors qu'un polariseur linéaire (5), disposé sur la trajectoire de rayon d'éclairage et/ou de reproduction, est amené à tourner progressivement.

**18.** Procédé d'émulation selon au moins l'une quelconque des revendications 16 et 17, dans lequel respectivement au moins une reproduction du masque et/ou de l'échantillon (1) est enregistrée pour au moins trois positions angulaires d'un élément optique à effet de polarisation (5).

**19.** Procédé d'émulation selon au moins l'une quelconque des revendications 16 à 18, dans lequel en plus ou en remplacement, une reproduction non polarisée du masque et/ou de l'échantillon (1) est enregistrée.

**20.** Procédé d'émulation selon au moins l'une quelconque des revendications 16 à 19, dans lequel les reproductions du masque et/ou de l'échantillon (1) sont enregistrées avec ou sans élément optique à effet de polarisation (5), disposé sur la trajectoire de rayon d'éclairage et/ou de reproduction, à différentes distances du plan focal.

**21.** Procédé d'émulation selon la revendication 20, dans lequel la ou les reproductions avec des éléments optiques à effet de polarisation sont enregistrées devant, dans ou derrière le plan focal et la reproduction sans élément optique à effet de polarisation (5) est enregistrée dans plusieurs plans devant et/ou dans et/ou derrière le plan focal.

**22.** Procédé d'émulation selon au moins l'une quelconque des revendications précédentes 16 à 21, dans lequel le degré et la direction de la polarisation pour plusieurs pixels du détecteur (6) sont décrits comme une matrice de polarisation, une matrice de Jones, un vecteur de Jones ou une autre description optique de polarisation.

**23.** Procédé d'émulation selon la revendication 16, dans lequel on peut omettre la détermination des propriétés de polarisation de la reproduction et la détermination du degré et de la direction de la polarisation pour différents pixels du détecteur (6) en supposant que les propriétés de polarisation de la reproduction correspondent à celles de l'éclairage.

**24.** Procédé d'émulation selon au moins l'une quelconque des revendications 16 à 23, dans lequel les reproductions sont soumises en fonction de la polarisation à une pondération de leur distribution d'intensité en ce que des fractions de l'intensité de la reproduction du masque et/ou de l'échantillon (1) sont décalées comme une fonction d'intensité dans différentes directions d'une certaine quantité, la répartition des différentes fractions s'effectuant en fonction de la polarisation.

**25.** Procédé d'émulation selon la revendication 24, dans lequel au moins 2 fractions de l'intensité sont décalées dans différentes directions, dans lequel les directions de décalage se trouvent au moins en partie en parallèle et/ou perpendiculairement à la direction de la polarisation.

**26.** Procédé d'émulation selon au moins l'une quelconque des revendications 24 et 25, dans lequel la répartition des différentes fractions s'effectue avec un rapport de 1+g à 1-g, où g est le degré de polarisation linéaire.

**27.** Procédé d'émulation selon au moins l'une quelconque des revendications précédentes 24 à 26, dans lequel les reproductions sont soumises en fonction de la polarisation à une pondération de leur distribution d'intensité en ce que la' reproduction du masque et/ou de l'échantillon (1) est décalée comme une fonction d'intensité d'une part en direction de la direction de polarisation déterminée d'une quantité $\pm D$ et d'autre part perpendiculairement à la direction de polarisation déterminée d'une quantité $\pm D$.

**28.** Procédé d'émulation selon la revendication 27, dans lequel la quantité D correspond par exemple à la condition

$$D = \frac{\lambda}{n_{Lack}\,4\sqrt{2}} \cdot \frac{c \cdot NA / n_{Lack} \big/ \arcsin(c \cdot NA / n_{Lack})}{1 / \sqrt{2} \big/ \arcsin(1/\sqrt{2})}$$

où c = constante $\leq$ 1, NA est l'ouverture numérique, $\lambda$ identifie la longueur d'onde et $n_{lack}$ correspond à l'indice de réfraction du milieu dans le plan focal dans lequel l'image est créée.

**29.** Procédé d'émulation selon au moins l'une quelconque des revendications 24 à 28, dans lequel les reproductions du masque et/ou de l'échantillon (1) sont additionnées aux positions (x+D, y), (x-D, y), (x, y+D) et (x, y-D) de façon pondérée ou non, x et y étant deux directions déterminées ou quelconques, orthogonales l'une à l'autre.

**30.** Procédé d'émulation selon au moins l'une quelconque des revendications 16 à 23, dans lequel, en partant de la reproduction, celle-ci est modifiée en ce que le détour par la distribution de pupille et/ou de sa reconstitution ou une convolution avec une image point adéquate, par exemple la différence de l'image point du système à haute et basse ouverture du côté reproduction, peut avoir lieu.

**31.** Procédé d'émulation selon la revendication 30, dans lequel les reproductions sont soumises en fonction de la polarisation à une pondération de leur distribution d'intensité en ce que pour tous les éléments du vecteur de Jones, du vecteur de Stokes ou de la matrice de polarisation des reproductions mesurées avec différents éléments optiques à effet de polarisation sur la trajectoire de rayon d'éclairage et/ou de reproduction ou d'une autre description optique de polarisation de la reproduction pour différents pixels du détecteur, une détermination de composantes de fréquence bidimensionnelle est exécutée, un facteur d'affaiblissement en fonction de la polarisation est intégré dans le calcul et une reconstitution d'image bidimensionnelle est exécutée.

**32.** Procédé d'émulation selon au moins l'une quelconque des revendications 30 et 31, dans lequel la pondération, au lieu d'être exécutée par une multiplication avec une fonction d'affaiblissement dans l'espace de fréquence, est exécutée par une convolution d'une fonction adéquate dans l'espace local, dans lequel la transformée de la fonction d'affaiblissement dans l'espace d'image est une fonction adéquate.

**33.** Procédé d'émulation selon au moins l'une quelconque des revendications 30 à 32, dans lequel le facteur d'affaiblissement en fonction de la polarisation est déterminé par l'angle entre le vecteur de fréquence local et la direction de polarisation et/ou la quantité du vecteur de fréquence locale.

**34.** Procédé d'émulation selon la revendication 33, dans lequel le facteur d'affaiblissement en fonction de la polarisation est calculé entre autres d'après le cosinus de l'angle formé par les vecteurs de champ E tridimensionnels dans l'espace image du système à haute ouverture.

**35.** Procédé d'émulation selon au moins l'une quelconque des revendications 30 à 34, dans lequel, pour plusieurs valeurs possibles du facteur d'affaiblissement, une moyenne pondérée ou non, la médiane, la valeur moyenne entre la plus petite et la plus grande valeur ou une autre valeur comprise dans la plage de variation est formée.

**36.** Procédé d'émulation selon la revendication 35, dans lequel la fonction de pondération est formée en tenant compte des propriétés et/ou de la polarisation de l'éclairage.

**37.** Procédé d'émulation selon au moins l'une quelconque des revendications 30 à 36, dans lequel des composantes de fréquence partiellement polarisées sont divisées en plusieurs fractions à polarisations différentes et le facteur d'affaiblissement est calculé individuellement pour les fractions.

**38.** Procédé d'émulation selon la revendication 37, dans lequel ces fractions sont polarisées de préférence en parallèle et/ou perpendiculairement à la direction de polarisation.

**39.** Procédé d'émulation selon au moins l'une quelconque des revendications 30 à 38, dans lequel des composantes de fréquence partiellement polarisées sont divisées en une fraction polarisée et une fraction non polarisée, la fraction non polarisée est considérée comme étant polarisée x à 50 % et polarisée y à 50 %, x et y étant deux directions déterminées ou quelconques, orthogonales l'une à l'autre, et le facteur d'affaiblissement en fonction de la polarisation est calculé séparément pour chacune des 3 fractions.

**40.** Procédé d'émulation selon au moins l'une quelconque des revendications 30 à 39, dans lequel les reproductions du masque et/ou de l'échantillon (1) se compensent avec ou sans élément optique à effet de polarisation (5) disposé sur la trajectoire de rayon d'éclairage et/ou de reproduction dans l'espace de fréquence.

**41.** Procédé d'émulation selon la revendication 40, dans lequel une reproduction globale est créée par une reconstitution d'image d'au moins une composante de la description optique de polarisation et/ou de l'intensité totale.

**42.** Procédé d'émulation selon au moins l'une quelconque des revendications 16 à 23, dans lequel les reproductions sont soumises en fonction de la pondération à une pondération de leur distribution d'intensité en ce que la reproduction du masque et/ou de l'échantillon est soumise à une convolution locale avec une image point normalisée pour plusieurs pixels du détecteur (6).

43. Procédé d'émulation selon la revendication 42, dans lequel en tant qu'image point normalisée, la convolution inverse de l'image point à haute ouverture est utilisée avec l'image point du microscope de contrôle.

44. Procédé d'émulation selon au moins l'une quelconque des revendications 42 et 43, dans lequel la convolution locale de la reproduction du masque et/ou de l'échantillon (1) s'effectue séparément pour plusieurs pixels du détecteur (6) avec l'image point normalisée pour des fractions de rayonnement à différentes polarisations.

45. Procédé d'émulation selon au moins l'une quelconque des revendications 42 à 44, dans lequel la convolution locale de la reproduction du masque et/ou de l'échantillon (1) s'effectue avec une image point normalisée pour au moins deux fractions de l'intensité de la reproduction, dans lequel la répartition des différentes fractions s'effectue en fonction de la polarisation et une fraction se trouve au moins de façon partiellement en parallèle et/ou perpendiculairement à la direction de la polarisation.

46. Procédé d'émulation selon au moins l'une quelconque des revendications 42 à 45, dans lequel la répartition sur différentes fractions s'effectue avec le rapport de 1+g à 1-g, où g est le degré de polarisation linéaire.

47. Procédé d'émulation selon la revendication 16, dans lequel l'unité d'évaluation regroupe des reproductions du masque et/ou de l'échantillon (1) pour des fractions de rayonnement à différentes polarisations par l'addition des distributions d'intensité en une image globale, des reproductions pour des fractions de rayonnement à différentes polarisation pouvant d'abord être soumises à une pondération de la distribution d'intensité.

48. Procédé d'émulation selon la revendication 47, dans lequel l'évaluation des reproductions s'effectue en tenant compte des propriétés de polarisation et prend en compte au moins en partie les effets vectoriels.

49. Procédé d'émulation selon au moins l'une quelconque des revendications 30 et 31, dans lequel un algorithme d'optimisation, par exemple de type récursif, sert à reconstituer la distribution de pupille qui peut alors être utilisée pour calculer ou prendre en compte l'effet vectoriel.

Figur 1

Figur 2

Figur 3

Figur 4

Figur 5

Figur 6

Figur 7

Figur 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6690469 B1

- US 6924893 B2